# EUROPEAN PATENT SPECIFICATION

(11) **EP 2 101 216 B1**
(45) Date of publication and mention of the grant of the patent: **27.07.2016**
(21) Application number: 09250665.8
(22) Date of filing: 10.03.2009
(51) Int. Cl.: G03F 7/00

(54) **Imprint method**
Druckverfahren
Procédé d'impression

(30) Priority: 12.03.2008 JP 2008063168; 12.03.2008 JP 2008063169; 25.12.2008 JP 2008331051
(43) Date of publication of application: 16.09.2009
(73) Proprietor: Ricoh Company, Ltd., Tokyo 143-8555 (JP)
(72) Inventor: Deguchi, Hiroshi, Yokohama-shi Kangawa (JP); Tanaka, Kawori, Suginami-ku, Tokyo (JP)
(74) Representative: Lamb, Martin John Carstairs

(56) References cited:
- WO-A1-03/079416
- WO-A2-03/023082
- US-A1- 2005 156 353
- US-A1- 2006 027 949
- US-A1- 2007 023 976
- YUNG-CHUN LEE ET AL: "Roller-based laser assisted direct imprinting for nanofabrication" NANO/MICRO ENGINEERED AND MOLECULAR SYSTEMS, 2008. NEMS 2008. 3RD IEEE INTERNATIONAL CONFERENCE ON, IEEE, PISCATAWAY, NJ, USA, 6 January 2008 (2008-01-06), pages 296-299, XP031263444 ISBN: 978-1-4244-1907-4

## Description

### BACKGROUND OF THE INVENTION

### 1. Field of the Invention

The present invention relates to an imprint method in which, a mold having a fine indented surface is irradiated with electromagnetic waves, and the fine indented shape is transferred to a to-be-transferred object.

### 2. Description of the Related Art

Recently, research and development for devices having fine structures processed with the use of nanometer-order processing technology are actively carried out. Nanoimprint technology is a method in which a mold having a size of nanometers is pressed to a substrate which is a to-be-transferred object, and a pattern of the mold is transferred to the substrate. This method has high productivity, and cost reduction is made possible.

In the nanoimprint technology, a thermal nanoimprint method and an optical nanoimprint method are mainstream methods. However, a laser-assisted direct imprint method, i.e., a LADI method has been proposed as a method which is suitable to carry out high resolution and high-speed processing. According to the LADI method, a mold in which a predetermined pattern is formed on molten quartz is made to come into contact with and is pressed onto a silicon substrate, and, with this state being maintained, XeCl excimer laser pulses are irradiated with. At this time, melting and liquefaction occur on a surface of the silicon substrate, and as a result, the predetermined pattern is transferred to the silicon substrate. Further, it has been suggested that, on the silicon substrate surface, a semiconductor material, a metal, an alloy, a polymer, or a ceramic may be formed. For the technologies, see Stephan Y. Chou et al., Appl. Phys. Lett, Vol. 67, Issue 21, pp. 3114-3116 (1995), and Japanese Laid-Open Patent Application No. 2005-521243.

However, the LADI method having been proposed has the following problems. That is, first, when a substrate made of a material which transmits laser light for irradiation having a predetermined wavelength is used, almost all of the laser light is transmitted by the substrate. As a result, a heat amount required for melting and liquefying the substrate surface may not be generated, and thus, transfer of a pattern of a mold may not be achieved. That is, the LADI method may not be used for a substrate made of a material which transmits laser light for irradiation.

It is noted that, according to Japanese Laid-Open Patent Application No. 2005-521243 mentioned above, it is suggested to form a semiconductor material, a metal, an alloy, a polymer or a ceramic on a substrate surface. However, the prior art document is silent for the purpose of forming such a material, and a specific method to solve the above-mentioned problem. Further, such a material formed on a substrate surface should be basically removed, and an extra process may occur therefor, and production cost may increase accordingly. Thus a method to form a material on the substrate surface may be disadvantageous.

Second, when a mold made of a material which does not transmit laser light of a predetermined wavelength for irradiation is used, the laser light is absorbed by the mold, and thus, a substrate surface may not be molten and liquefied. That is, only a mold which is made of a material which transmits laser light for irradiation may be used in the LADI method.

Other than these, since an excimer laser is a gas laser, stability when used for a long term may be problematic, and maintenance may be required. Further, a direction in which laser light is irradiated with is limited to a direction from the side of a mold made of a material which transmits laser light of a predetermined wavelength. Therefore, design freedom may be degraded.

US 2007/0023976 A1 relates to a lithographic apparatus that has an imprint template and a substrate table configured to hold a substrate, the imprint table having a patterned surface, a layer of heat absorbing material provided on the patterned surface of the imprint template.

US 2005/156353 A1 relates to a method of increasing the flow rate of an imprinting layer disposed between a source of radiation and a target to facilitate pattern formation. In the method, infrared radiation is directed toward the target with the imprinting layer substantially transparent to infrared radiation. The target substantially absorbs the infrared radiation to create a thermal energy, and the thermal energy is subsequently transferred to the liquid. This causes a temperature rise of the liquid, which purportedly increases a flow rate of the imprinting layer and reduces the time required to fill the features defined on a mold.

WO 03/023082 A2 relates to an automated process for microcontact printing, which comprises the steps of: providing a substrate and a stamp; automatically aligning the substrate and stamp so that the stamp is aligned relative to the substrate to impart a pattern to the substrate at a desired location and with a desired orientation on the substrate; applying an ink to the stamp, the ink including a molecular species adapted to form a self-assembling monolayer on the substrate; contacting the stamp and the substrate; and separating the stamp from the substrate.

In Yung-Chun Lee et al. (Proceedings of the 3rd IEEE International Conference on Nano/Micro Engineered and Molecular Systems, 6-9 January 2008, pages 296-299) a nanofabrication method is described based on laser-assisted direct imprinting (LADI) technology. In the method, a quartz roller optically focuses an incident UV laser light into a line onto a silicon substrate, and mechanically compresses a quartz mold against the silicon substrate.

US 2006/0027949 A1 relates to a microstructure imprint device comprising a supporting plate, a substrate, a moldable layer, a mold, and a microwave source.

### SUMMARY OF THE INVENTION

The present invention has been devised in consideration of the problems, and an object of the present invention is to provide an imprint method of higher practicability, by which, the problems in the LADI method can be solved,

According to the present invention, an imprint method of, in a state in which an indented surface of a mold comes in contact with a to-be-transferred surface of a to-be-transferred object, irradiating with electromagnetic waves to soften the to-be-transferred surface, and transferring an indented shape of the indented surface of the mold to the to-be-transferred surface, includes a heating layer forming step of forming, on the indented surface, a heating layer which absorbs the electromagnetic waves and generates heat, wherein the heating layer has a configuration of a plurality of layers which are laminated together; and a softening step of irradiating the heating layer with the electromagnetic waves, through the mold or the to-be-transferred object, at least one of the mold and the to-be-transferred object being made of a material which transmits the electromagnetic waves, causing the heating layer to generate heat, and softening the to-be-transferred surface.

According to another aspect of the present invention, an imprint method of, in a state in which an indented surface of a mold comes in contact with a to-be-transferred surface of a to-be-transferred object, irradiating with electromagnetic waves to soften the to-be-transferred surface, and transferring an indented shape of the indented surface to the to-be-transferred surface, includes a heating layer forming step of forming, on the to-be-transferred surface, a heating layer which absorbs the electromagnetic waves and generates heat, wherein the heating layer has a configuration of a plurality of layers which are laminated together; and a softening step of irradiating the heating layer with the electromagnetic waves, through the mold or the to-be-transferred object, at least one of the mold and the to-be-transferred object being made of a material which transmits the electromagnetic waves, causing the heating layer to generate heat, and softening the to-be-transferred surface.

The mold includes an indented surface used in an imprint method in which electromagnetic waves are used, and a heating layer formed on the indented surface, wherein the heating layer absorbs the electromagnetic waves and generates heat.

Other objects, features and advantages of the present invention, which is defined by the appended claims, will become more apparent from the following detailed description when read in conjunction with the accompanying drawings.

### BRIEF DESCRIPTION OF THE DRAWINGS

FIGS. 1, 2, 3, 4, 5 and 6 depict schematic views illustrating an imprint method according to a first mode for carrying out the present invention;
FIG. 7 schematically illustrates a relationship between an electromagnetic wave (14) absorbing amount, thermal conductivity and a film thickness of a heating layer 12, and a heat quantity generated by the heating layer 12;
FIGS. 8, 9, 10, 11, 12 and 13 depict schematic views illustrating a both-side imprint method according to a second mode for carrying out the present invention;
FIG. 14 is a plan view which illustrates a general shape of a mold 41 used in an embodiment 1 of the present invention;
FIG. 15 is a sectional view which illustrates the general shape of the mold 41 used in the embodiment 1 of the present invention;
FIG. 16 illustrates a bonded sample 46;
FIG. 17 depicts interference colors on an indented surface 41a of the mold 41 and a to-be-transferred surface 43a of a to-be-transferred object 43;
FIG. 18 depicts a full light quantity signal 47, a trigger signal 48 and a push-pull signal 49 when tracking servo is turned off;
FIG. 19 depicts the full light quantity signal 47, trigger signal 48 and push-pull signal 49 when tracking servo is turned on;
FIG. 20 is a photomicrograph of a hologram sheet which is a mold 51;
FIG. 21 is an AFM image depicting an indented state on the hologram sheet which is the mold 51;
FIG. 22 illustrates a bonded sample 56;
FIG. 23 is a photomicrograph of a to-be-transferred surface 53a of a to-be-transferred object 53;
FIG. 24 is an AFM image depicting the to-be-transferred surface 53a of the to-be-transferred object 53;
FIG. 25, 26, 27, 28, 29, 30 and 31 depict schematic views illustrating an imprint method according to a third mode for carrying out the present invention;
FIG. 32 schematically illustrates a relationship between an electromagnetic wave (114) absorbing amount, thermal conductivity and a film thickness of a heating layer 112, and a heat quantity generated by the heating layer 112;
FIGS. 33, 34, 35, 36, 37, 38 and 39 depict schematic views illustrating a both-side imprint method according to a fourth mode for carrying out the present invention;
FIG. 40 is a plan view which illustrates a general shape of a mold 143 used in an embodiment 12 of the present invention;
FIG. 41 is a sectional view which illustrates the general shape of the mold 143 used in the embodiment 12 of the present invention;
FIG. 42 illustrates a bonded sample 146;
FIG. 43 depicts a full light quantity signal 147, a trigger signal 148 and a push-pull signal 149 when tracking servo is turned off;
FIG. 44 depicts the full light quantity signal 147, trigger signal 148 and push-pull signal 149 when tracking servo is turned on;
FIG. 45 is a photomicrograph of a hologram sheet which is a mold 153;
FIG. 46 is an AFM image depicting an indented state on the hologram sheet which is the mold 153;
FIG. 47 illustrates a bonded sample 156;
FIG. 48 is a photomicrograph of a to-be-transferred surface 151a of a to-be-transferred object 151;
FIG. 49 is an AFM image depicting the to-be-transferred surface 151a of the to-be-transferred object 151;
FIG. 50 is a photomicrograph of a texture structure formed on a surface of a quartz substrate which is a mold; and
FIG. 51 illustrates a light transmission spectrum of a to-be-transferred object 141 to which the texture structure has been transferred.

### DESCRIPTION OF REFERENCE NUMERALS

11, 21, 41, 51, 113, 123, 143, 153 mold
11a, 21a, 21b, 41a, 51a, 113a, 123a, 123b, 143a, 153a indented surface of mold
12, 22, 32, 42, 52, 112, 122, 132, 142, 152 heating layer
13, 23, 33, 43, 53, 63, 111, 121, 131, 141, 151, 161 to-be-transferred object
13a, 23a, 33a, 43a, 53a, 63a, 111a, 121a, 131a, 141a, 151a, 161a to-be-transferred surface of to-be-transferred object
14, 24, 114, 124 electromagnetic waves
41b, 43b interference colors
45, 145 groove
46, 56, 146, 156 bonded sample
47, 147 full light quantity signal
48, 148 trigger signal
49, 149 push-pull signal

### DETAILED DESCRIPTION OF THE PREFERRED EMBODIMENTS

Below, with reference to figures, modes for carrying out the present inventions will be described.

### <First Mode for Carrying out the Present Invention>

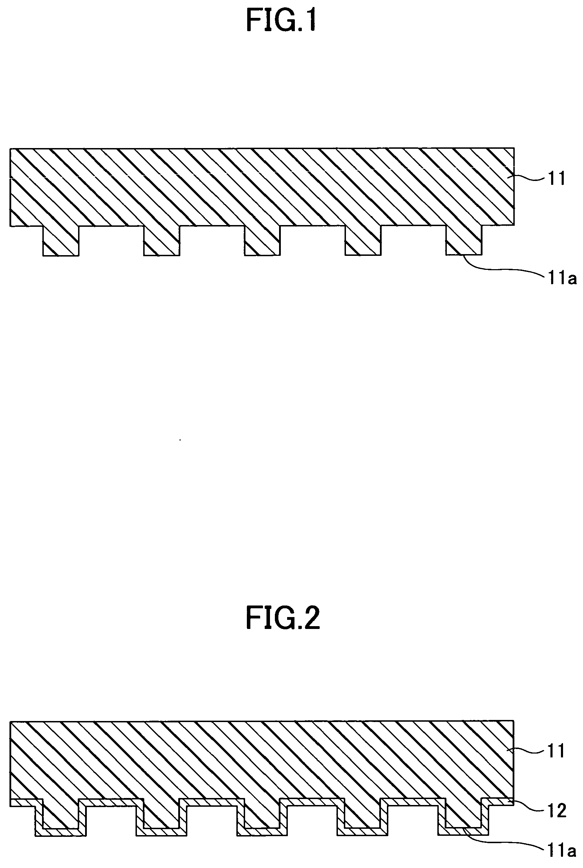

With reference to FIGS. 1-6, an imprint method according to a first mode for carrying out the present invention will be described. FIGS. 1-6 schematically illustrate the imprint method according to the first mode for carrying out the present invention. In FIGS. 1-6, 11 represents a mold, 12 represents a heating layer, 13 represents a to-be-transferred object, and 14 represents electromagnetic waves. Further, 11a represents an indented surface of the mold 11, and 13a represents a to-be-transferred surface of the to-be-transferred object 13.

First, in a process depicted in FIG. 1, i.e., a mold forming process, the mold 11 having the indented surface 11a is formed. The indented surface 11a is a surface including a nanometer-scale indented pattern, for example. As a material of the mold 11, for example, a molding material or such commonly used for a nanoimprint method may be used, for example, a resin typified by a polycarbonate resin, an acrylic resin, an epoxy resin, a polystyrene resin, an acrylonitrile-styrene copolymer, a polyethylene resin, a polypropylene resin, a silicone resin, a fluorine resin, a ABS resin, a urethane resin or such, a crystal or ceramics material of an oxide typified by SiO₂, Al₂O₃ or such, a nitride typified by SiN, AlN or such, a carbide typified by SiC, GC (i.e., glassy carbon) or such, a metal material typified by Ni, Ta or such, may be used. The indented surface 11a of the mold 11 may be formed in a FIB (i.e.,. Focused Ion Beam) process or such. The FIB process is such that, as well-known, a Ga (i.e., gallium) ion beam which is sufficiently narrowed is used, and a complicate shape can be formed with an accuracy of a submicron level.

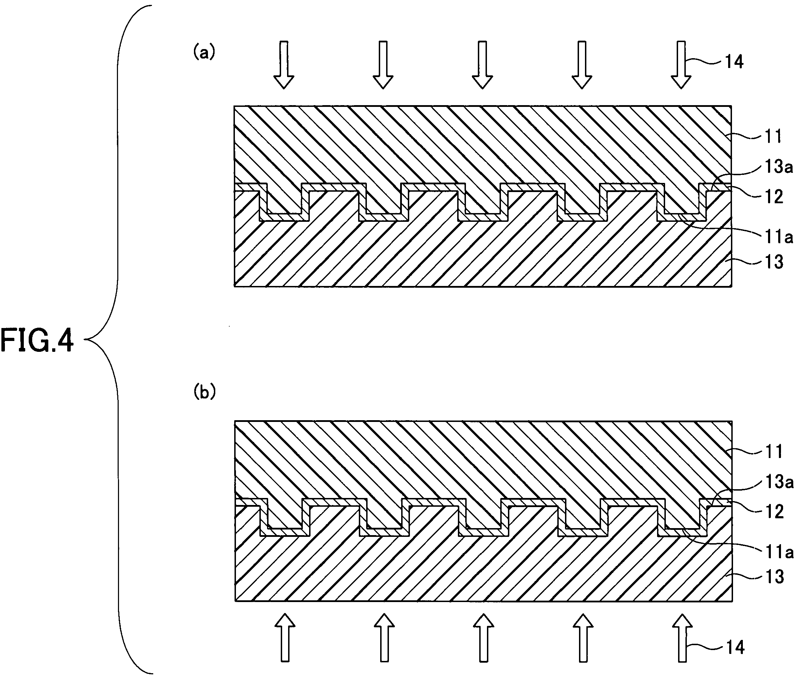

Next, in a process depicted in FIG. 2, i.e., a heating layer forming process, a heating layer 12 is formed on the indented surface 11a of the mold 11. The heating layer 12 is made of a heating material which, in a process depicted in FIG. 4 later, absorbs electromagnetic waves 14 which are irradiated with through the mold 11 or the to-be-transferred object 13, which is made of a material which transmits the electromagnetic waves 14, and generates such a heat amount to be able to soften the to-be-transferred surface 13a of the to-be-transferred object 13.

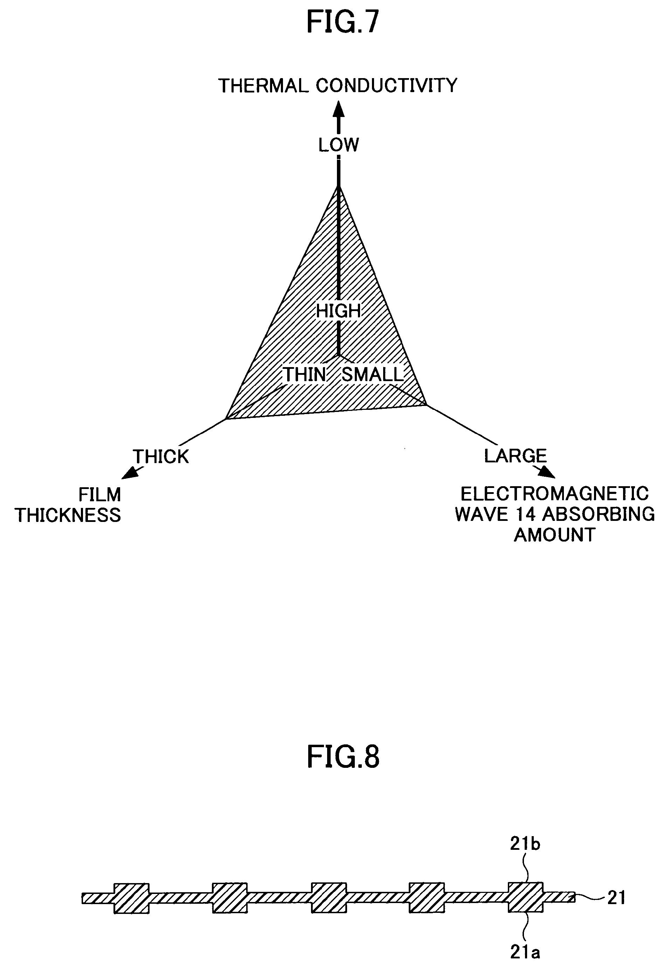

The heat amount generated by the heating layer 12 is adjusted by means of an electromagnetic wave 14 absorbing amount and heat conductivity of the material of the heating layer 12 and a film thickness of the heating layer 12. FIG. 7 schematically illustrates a relationship between the electromagnetic wave 14 absorbing amount, the heat conductivity and the film thickness of the heating layer 12, and the heat amount generated by the heating layer 12. In FIG. 7, an area of an oblique line part defined by a triangle corresponds to the heat amount. By optimizing a balance between the electromagnetic wave 14 absorbing amount, the heat conductivity and the film thickness of the heating layer 12 with respect to the to-be-transferred object 13 to which the indented pattern of the indented surface 11a is transferred, it is possible to satisfactorily transfer the indented shape of the indented surface 11a.

For example, a material having predetermined electromagnetic wave 14 absorbing amount and predetermined heat conductivity is selected, and an optimum film thickness of the heating layer 12 is determined such that the heating layer 12 generates the necessary heat amount in consideration of the predetermined electromagnetic wave 14 absorbing amount and the predetermined heat conductivity. The absorbing amount and heat conductivity may preferably fall within respective ranges of, for example, on the order of 50 through 100 % and 20 through 400 W/m/k.

As a material of the heating layer 12, a material, which has satisfactory releasability from the to-be-transferred object 13 and also, generates heat in the same degree also when irradiation of electromagnetic waves 14 is carried out a plurality of times, is preferable. Specifically, any one of Si and Ge which are semiconductors, Sn, Sb and Bi which are semimetals, Cu, Au, Pt and Pd which are precious metals and so forth, Zn, Ni, Co and Cr which are transition metals, and alloys thereof, carbides typified by SiC, TiC and so forth, ceramics such as oxygen deficiency oxide typified by SiOx, GeOx and so forth, and so forth, is preferable. Further, it is preferable that a material of the heating layer 12 includes a phase change material. Since the phase change material has large electromagnetic wave 14 absorbing amount and heat generating amount, it is possible to reduce an optimum film thickness of the heating layer 12 to generate the necessary heat amount, and thus, it is possible to improve productivity.

As the phase change material, one may be appropriately selected from materials used as materials of recording layers of rewritable-type optical recording media. For example, it is preferable to use a material which includes one or more elements selected from Sb, Ge, Ga, In, Zn, Mn, Sn, Ag, Mg, Ca, Ag, Bi, Se and Te. As the phase change material, a desired material may be used in consideration of a thermal characteristic and an optical characteristic

A GeSbTe alloy, an AgInSbTe alloy, an AgInSbTeGe alloy, a GaSbSnGe alloy, GeSbSnMn alloy, a GeInSbTe alloy, a GeSbSnTe alloy and so forth are preferable.

Further, the heating layer 12 has a configuration of not only a single layer but a plurality of layers which are laminated together. By using such a configuration of a plurality of layers, which is referred to as a multi-layer configuration, it is possible to adjust not only a heating amount but also temperature maintaining, a cooling speed and so forth. Thus, it is possible to carry out the imprint method satisfactorily. Further, by selecting a material which can be used a plurality of times as a material of the heating layer 12, the mold 11 can be used a plurality of times. Further, by providing the heating layer 12 on the mold 11, it is possible to avoid adhesion of a heating material to the to-be-transferred surface 13a of the to-be-transferred object 13. Therefore, it is not necessary to clean the to-be-transferred surface 13a.

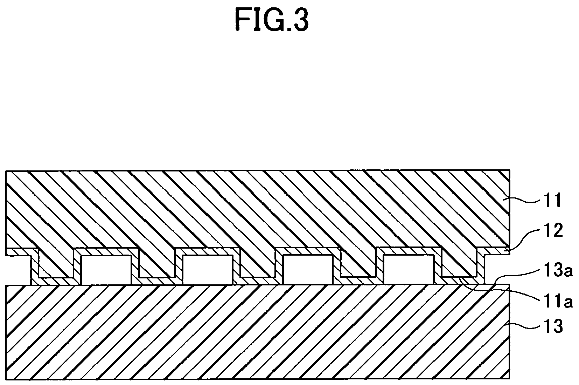

Next, in a process of FIG. 3, protruding portions of the heating layer 12 formed on the indented surface 11a of the mold 11 are made to come into contact with the to-be-transferred surface 13a of the to-be-transferred object 13. As a material of the to-be-transferred object 13, for example, a resin typified by a polycarbonate resin, an acrylic resin, an epoxy resin, a polystyrene resin, an acrylonitrile-styrene copolymer, a polyethylene resin, a polypropylene resin, a silicone resin, a fluorine resin, a ABS resin, a urethane resin or such, a crystal or ceramics material of an oxide typified by SiO₂, Al₂O₃ or such, a nitride typified by SiN, AlN or such, a carbide typified by SiC, GC (i.e., glassy carbon) or such, or a material which is used as a so-called substrate, such as Si, may be used. The above-mentioned to come in contact with is carried out in such a manner that the mold 11 and the to-be-transferred object 13 are pressed to one another strongly by an external pressure. Specifically, a special pressing machine may be used to press by mechanical force. However, it is preferable to use a vacuum adsorption method in which a vacuum is formed between the heating layer 12 and the to-be-transferred surface 13a of the to-be-transferred object 13, and thus, an external atmospheric pressure is used to press the heating layer 12 and the to-be-transferred surface 13a of the to-be-transferred object 13 together.

The vacuum adsorption method can be carried out with the use of a general-purpose apparatus, and it is easy to maintain an adsorption state. Further, even when the mold 11 or the to-be-transferred object 13 does not have high mechanical strength, it is possible to obtain such a pressing force which is minimum so that the mold 11 and the to-be-transferred object 13 can be prevented from being broken. By using vacuum adsorption, it is possible to carry out the imprint method satisfactorily. Vacuum adsorption can be carried out with the use of an existing vacuum bonding machine which is used to bond two substrates for forming a DVD-ROM which is a well-known optical recording medium in a vacuum state in which no gas which may cause voids exists.

Next, in a process of FIG. 4, i.e., a softening process, the heating layer 12 is irradiated with the electromagnetic waves 14 through the mold 11 or the to-be-transferred object 13, which is made of a material which transmits the electromagnetic waves 14. Thereby, the heating layer 12 is made to generate heat, and therewith, the to-be-transferred surface 13a of the to-be-transferred object 13 is softened. The mold 11 and the to-be-transferred object 13 are strongly pressed to one another through the heating layer 12, for example, by means of vacuum adsorption, as mentioned above. Therefore, when the to-be-transferred surface 13a of the to-be-transferred object 13 is thus softened as a result of the heating layer 13 generating heat which is irradiated with the electromagnetic waves 14, the to-be-transferred surface 13a of the to-be-transferred object 13 changes in its shape according to an indented shape of the indented surface 11a of the mold 11. It is noted that, a melting point or a softening point of the material of the mold 11 should be equal to or higher than a melting point or a softening point of the material of the to-be-transferred object 13.

At least one of the mold 11 and the to-be-transferred object 13 should be made of a material which transmits the electromagnetic waves 14. When the mold 11 is made of a material which transmits the electromagnetic waves 14, as depicted in FIG. 4, (a), the heating layer 12 is irradiated with the electromagnetic waves 14 through the mold 11. When the to-be-transferred object 13 is made of a material which transmits the electromagnetic waves 14, as depicted in FIG. 4, (b), the heating layer 12 is irradiated with the electromagnetic waves 14 through the to-be-transferred object 13. Further, when both the mold 11 and the to-be-transferred object 13 are made of materials which transmit the electromagnetic waves 14, either the heating layer 12 may be irradiated with the electromagnetic waves 14 through the mold 11 as depicted in FIG. 4, (a), or the heating layer 12 may be irradiated with the electromagnetic waves 14 through the to-be-transferred object 13 as depicted in FIG. 4, (b).

A wavelength of the electromagnetic waves 14 may be preferably equal to or shorter than 2000 nm. When a wavelength is longer than 2000 nm, there are few heating materials which sufficiently absorb the electromagnetic waves. Laser light is most preferable as the electromagnetic waves 14. This is because, when laser light is used, it is possible to increase light intensity per unit area, i.e., energy density, on the heating layer 12. Further, as a laser which emits laser light, a semiconductor laser is especially preferable. In fact, the semiconductor laser is small-sized, can be easily maintained, is inexpensive and has a long life.

In the softening process depicted in FIG. 4, it is preferable to carry out a focusing process in which the electromagnetic waves 14 emitted by a light source are focused on the heating layer 12. By carrying out the focusing process, it is possible to efficiently carry out irradiation with the electromagnetic waves 14. Further, it is preferable to carry out focus servo control in the focusing process when the imprint method is carried out in such a manner that an optical head (not depicted) having the light source which emits the electromagnetic waves 14, or the mold 11 and to-be-transferred object 13, or both, are two-dimensionally moved. By carrying out the focus servo control, it is possible to cancel mechanical errors and positively focus the electromagnetic waves 14 on the heating layer 12. Thus, it is possible to carry out the imprint method satisfactorily.

The above-mentioned case where the imprint method is carried out in such a manner that an optical head (not depicted) having the light source which emits the electromagnetic waves 14, or the mold 11 and to-be-transferred object 13, or both, are two-dimensionally moved, will now be described. Such a case is a case where, for example, in an embodiment 1 described later or such, the electromagnetic waves 14 are irradiated with, while, the mold 11 and the to-be-transferred object 13 which are pressed to one another by means of vacuum adsorption are placed on a turn table and are rotated. The focus servo may be carried out in a well-known method, which is commonly used when laser light is made to follow and is focused on a rotated optical recording medium when information is recorded to or reproduced from the optical recording medium.

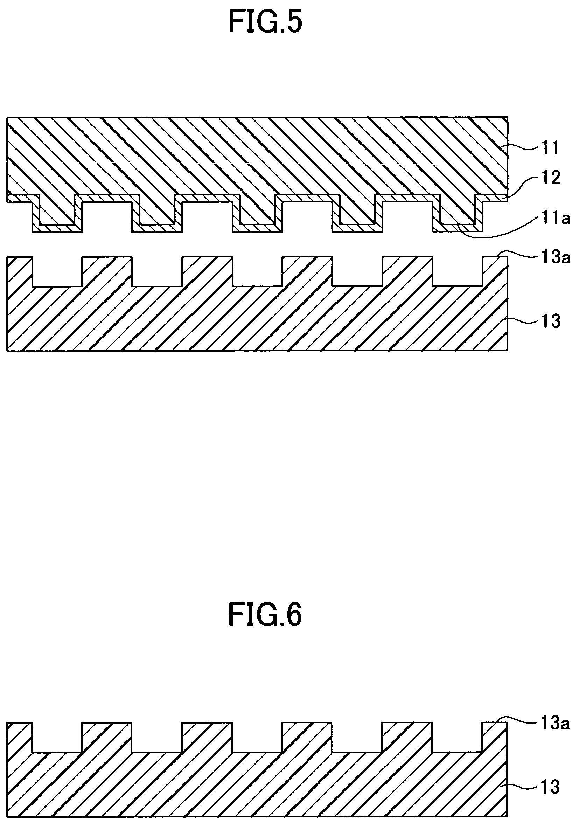

Next, in a process, i.e., a releasing process, as depicted in FIG. 5, the mold 11 is removed from the to-be-transferred object 13, and thus, as depicted in FIG. 6, the indented shape of the indented surface 11a of the mold 11 is transferred to the to-be-transferred surface 13a of the to-be-transferred object 13.

In an imprint method of the related art, a to-be-transferred surface of a to-be-transferred object made of a material which does not transmit electromagnetic waves is irradiated with electromagnetic waves through a mold which transmits the electromagnetic waves. Thus, the to-be-transferred surface of the to-be-transferred object is softened, and an indented shape of an indented surface of the mold is transferred to the to-be-transferred surface of the to-be-transferred object. That is, in the related art, a material of the mold is limited to a material which transmits the electromagnetic waves, and a material of the to-be-transferred object is limited to a material which does not transmit the electromagnetic waves (i.e., a material which absorbs the electromagnetic waves and generates heat).

In the imprint method according to the first mode for carrying out the present invention, the heating layer 12 which absorbs the electromagnetic waves 14 and generates heat is formed on the indented surface 11a of the mold 11, the heating layer 12 is irradiated with the electromagnetic waves 14, the heating layer 12 is thus made to generate heat, whereby the to-be-transferred surface 13a of the to-be-transferred object 13 is softened. Therefore, at least any one of the mold 11 and the to-be-transferred object 13 should be made of a material which transmits the electromagnetic waves 14.

That is, in the imprint method according to the first mode for carrying out the present invention, not only a combination of a mold made of a material which transmits electromagnetic waves and a to-be-transferred object made of a material which does not transmit the electromagnetic waves used in the imprint method in the related art, but also another combination of a mold made of a material which does not transmit electromagnetic waves and a to-be-transferred object made of a material which transmits the electromagnetic waves may be used. Also, further another combination of a mold made of a material which transmits electromagnetic waves and a to-be-transferred object made of a material which transmits the electromagnetic waves, may be used. Thus, it is possible to provide an imprint method which has highly practicability.

Further, in the mold 11 according to the first mode for carrying out the present invention, the heating layer 12 which absorbs the electromagnetic waves 14 and generates heat is formed on the indented surface 11a of the mold 11, the heating layer 12 is irradiated with the electromagnetic waves 14, the heating layer 12 is thus made to generate heat, whereby the to-be-transferred surface 13a of the to-be-transferred object 13 is softened. Therefore, it is possible to transfer the indented shape of the indented surface 11a, also to the to-be-transferred surface 13a of the to-be-transferred object 13 made of a material which transmits the electromagnetic waves 14.

### <Second Mode for carrying out the Present Invention>

With reference to FIGS. 8 through 13, an imprint method in a second mode for carrying out the present invention will be described. The imprint method in the second mode for carrying out the present invention is different from the imprint method in the first mode for carrying out the present invention in that, in the second mode for carrying out the present invention, a mold having two indented surfaces is used, and indented shapes of the two indented surfaces are transferred to to-be-transferred surfaces of two to-be-transferred objects.

FIGS. 8-13 schematically illustrate the imprint method according to the second mode for carrying out the present invention. In FIGS. 8-13,21 represents a mold, 22 and 32 represent heating layers, 23 and 33 represent to-be-transferred objects, and 24 represents electromagnetic waves. Further, 21a and 21b represent indented surfaces of the mold 21, and 23a and 33a represent to-be-transferred surfaces of the to-be-transferred objects 23 and 33.

First, in a process depicted in FIG. 8, i.e., a mold forming process, the mold 21 having the indented surfaces 21a and 21b is formed. The indented surfaces 21a and 21b are surfaces including nanometer-scale indented patterns for example. As a material of the mold 21, for example, a molding material or such commonly used for a nanoimprint method may be used, for example, a resin typified by a polycarbonate resin, an acrylic resin, an epoxy resin, a polystyrene resin, an acrylonitrile-styrene copolymer, a polyethylene resin, a polypropylene resin, a silicone resin, a fluorine resin, a ABS resin, a urethane resin or such, a crystal or ceramics material of an oxide typified by SiO₂, Al₂O₃ or such, a nitride typified by SiN, AlN or such, a carbide typified by SiC, GC (i.e., glassy carbon) or such, or a metal material typified by Ni, Ta or such, may be used. A material having a form of a film is especially preferable. The indented surfaces 21a and 21b of the mold 21 may be formed by means of a FIB (i.e., Focused Ion Beam) process or such. The FIB process is such that, as well-known, a Ga (i.e., gallium) ion beam which is sufficiently narrowed is used, and a complicate shape can be formed with an accuracy of a submicron level.

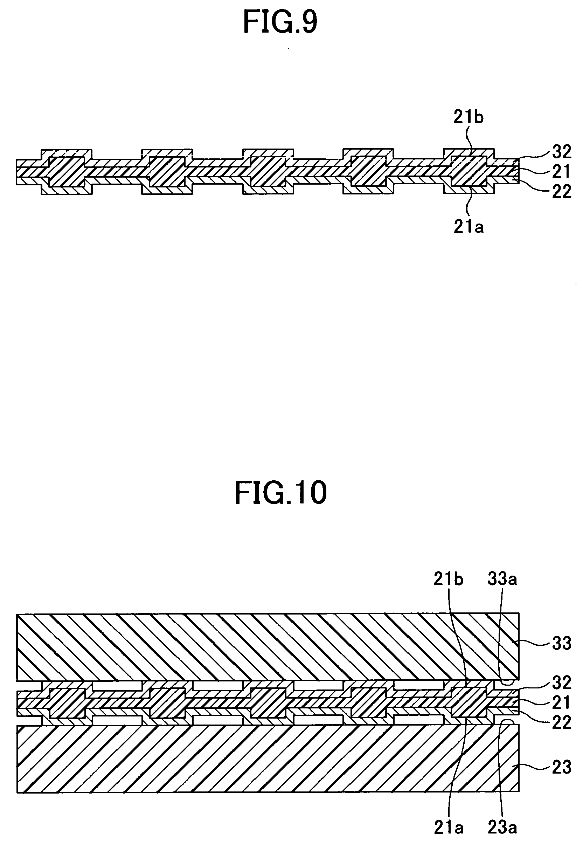

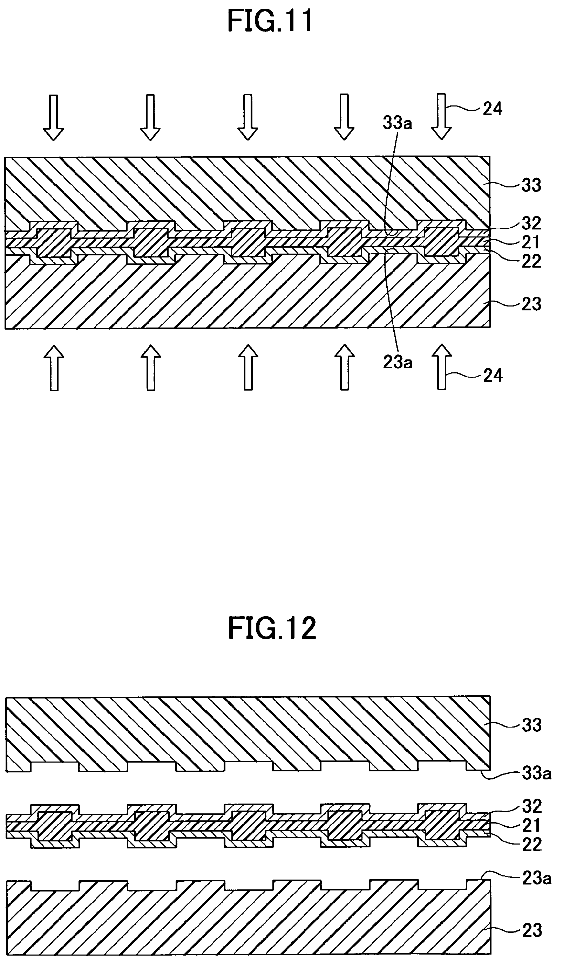

Next, in a process depicted in FIG. 9, i.e., a heating layer forming process, the heating layers 22 and 32 are formed on the indented surfaces 21a and 21b of the mold 21. The heating layers 22 and 32 are made of heating materials which, in a process depicted in FIG. 11 later, absorb the electromagnetic waves 24, which are irradiated with through the to-be-transferred objects 23 and 33, which are made of materials which transmit the electromagnetic waves 24, and generates such a heat amount to be able to soften to-be-transferred surfaces 23a and 33a of the to-be-transferred objects 23 and 33. Adjustment of a heat amount to be generated from the heating layers 22 and 32, materials of the heating layers 22 and 33, and so forth, are the same as those of the heating layer 12 used in the imprint method according to the first mode for carrying out the present invention, and duplicate description will be omitted.

Next, in a process of FIG. 10, protruding portions of the heating layers 22 and 32 formed on the indented surfaces 21a and 21b of the mold 21 are made to come into contact with the to-be-transferred surfaces 23a and 33a of the to-be-transferred objects 23 and 33. As materials of the to-be-transferred objects 23 and 33, for example, a resin typified by a polycarbonate resin, an acrylic resin, an epoxy resin, a polystyrene resin, an acrylonitrile-styrene copolymer, a polyethylene resin, a polypropylene resin, a silicone resin, a fluorine resin, a ABS resin, a urethane resin or such, a crystal or ceramics material of an oxide typified by SiO₂, Al₂O₃ or such, a nitride typified by SiN, AlN or such, a carbide typified by SiC, GC (i.e., glassy carbon) or such, or a material which is used as a so-called substrate, such as Si, may be used. The above-mentioned to come in contact with is carried out in such a manner that the mold 21 and each of the to-be-transferred objects 23 and 33 are pressed to one another strongly by an external pressure. Specifically, a special pressing machine may be used to press the members with mechanical force. However, it is preferable to use a vacuum adsorption method in which a vacuum is formed between each of the heating layers 22 and 32 and the respective one of the to-be-transferred surfaces 23a and 33a of the to-be-transferred objects 23 and 33, and thus, an external atmospheric pressure is used to press the heating layers 22 and 32 and the to-be-transferred surfaces 23a and 33a of the to-be-transferred objects 23 and 33 to each other. Because the vacuum adsorption is the same as that used in the imprint method according to the first mode for carrying out the present invention, duplicate description will be omitted.

Next, in a process of FIG. 11, i.e., a softening process, each of the heating layers 22 and 32 is irradiated with the electromagnetic waves 24 through each of the to-be-transferred objects 23 and 33, which are made of materials which transmit the electromagnetic waves 24. Thereby, the heating layers 22 and 32 are made to generate heat, and thus, the to-be-transferred surfaces 23a and 33a of the to-be-transferred objects 23 and 33 are softened. The mold 21 and each of the to-be-transferred objects 23 and 33 are strongly pressed to one another through each of the heating layers 22 and 32, for example, by means of vacuum adsorption. Therefore, when the to-be-transferred surfaces 23a and 33a of the to-be-transferred objects 23 and 33 are thus softened as a result of the heating layers 22 and 32 generating heat by means of the electromagnetic waves 24 being irradiated with, the to-be-transferred surfaces 23a and 33a of the to-be-transferred object 23 and 33 change in their shapes according to the indented shapes of the indented surfaces 21a and 21b of the mold 21. It is noted that, a melting point or a softening point of the material of the mold 21 is equal to or higher than a melting point or a softening point of the material of each of the to-be-transferred objects 23 and 33.

Both to-be-transferred objects 23 and 33 should be made of materials which transmit the electromagnetic waves 24. The heating layers 22 and 32 may be irradiated with the electromagnetic waves 24 through the to-be-transferred objects 23 and 33 one by one in sequence. However, by irradiating the heating layers 22 and 32 with the electromagnetic waves 24 from both sides of the to-be-transferred objects 23 and 33 simultaneously, productivity can be improved. As a wavelength of the electromagnetic waves 24, and so forth, are the same as those in the case of the imprint method according to the first mode for carrying out the present invention, duplicate description will be omitted.

In the softening process depicted in FIG. 11, it is preferable to carry out a focusing process in which the electromagnetic waves 24 emitted by a light source are focused on the heating layers 22 and 32. By carrying out the focusing process, it is possible to efficiently carry out irradiation with the electromagnetic waves 24. Further, it is preferable to carry out focus servo control in the focusing process when the imprint method is carried out in such a manner that an optical head (not depicted) having the light source which emits the electromagnetic waves 24, or the mold 21 and the to-be-transferred objects 23 and 33, or both, are two-dimensionally moved. By carrying out the focus servo control, it is possible to cancel mechanical errors and positively focus the electromagnetic waves 24 on the heating layers 22 and 32. Thus, it is possible to carry out the imprint method satisfactorily.

The above-mentioned case where the imprint method is carried out in such a manner that an optical head (not depicted) having the light source which emits the electromagnetic waves 24, or the mold 21 and the to-be-transferred objects 23 and 33, or both, are two-dimensionally moved, will now be described. Such a case is a case where, for example, in an embodiment 1 described later or such, the electromagnetic waves 24 are irradiated with, while, the mold 21 and each of the to-be-transferred objects 23 and 33 which are pressed to one another by means of vacuum adsorption are placed on a turn table and are rotated. The focus servo control may be carried out in a well-known method which is one used when laser light is made to follow and is focused on a rotated optical recording medium, when information is recorded to or reproduced from the optical recording medium.

It is noted that, in a case where the electromagnetic waves 24 are irradiated with from both sides of the to-be-transferred objects 23 and 33 simultaneously, while, the mold 21 and each of the to-be-transferred objects 23 and 33 which are pressed to one another by means of vacuum adsorption are placed on a turn table and are rotated, a mechanism which is different from an information recording/reforming apparatus in the prior art is required, such that, for example, two optical heads are provided on both sides of the to-be-transferred objects 23 and 33. However, such a mechanism may be prepared within a scope of the prior art.

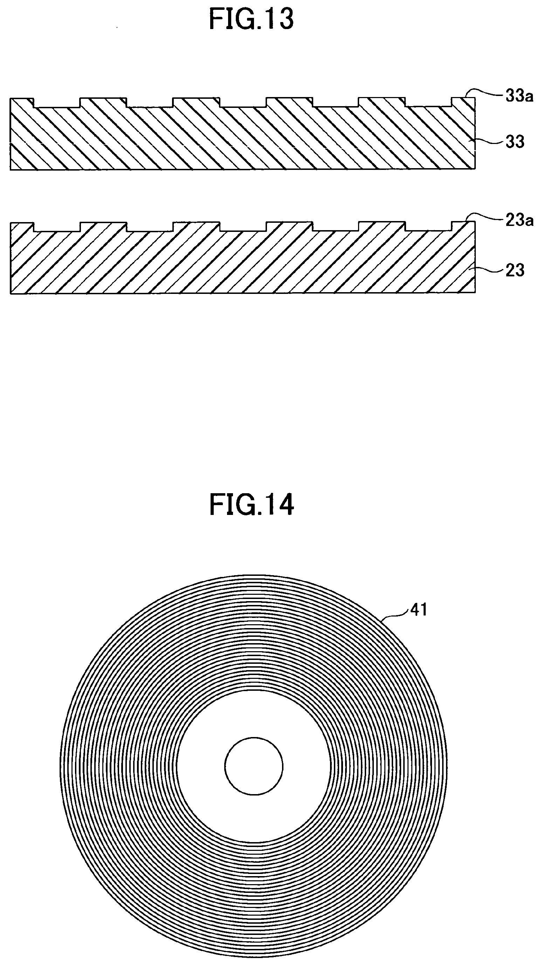

Next, in a process, i.e., a releasing process, as depicted in FIG. 12, the mold 21 is released from each of the to-be-transferred objects 23 and 33, and thus, as depicted in FIG. 13, the indented shapes of the indented surfaces 21a and 21b of the mold 21 are transferred to the to-be-transferred surfaces 23a and 33a of the to-be-transferred objects 23 and 33, respectively.

In an imprint method in the related art, a to-be-transferred surface of a to-be-transferred object made of a material which does not transmit electromagnetic waves is irradiated with the electromagnetic waves through a mold which transmits the electromagnetic waves. Thus, the to-be-transferred surface of the to-be-transferred object is softened, and an indented shape of an indented surface of the mold is transferred to the to-be-transferred surface of the to-be-transferred object. That is, in the related art, a material of the mold is limited to a material which transmits the electromagnetic waves, and a material of the to-be-transferred object is limited to a material which does not transmit the electromagnetic waves (i.e., a material which absorbs the electromagnetic waves and generates heat). Therefore, in the related art, it is not possible to perform an imprint method from both sides of to-be-transferred objects which come into contact with a mold on both sides.

In the imprint method according to the second mode for carrying out the present invention, the heating layers 22 and 32 which absorb the electromagnetic waves 24 and generate heat are formed on the indented surfaces 21a and 21b of the mold 21, the heating layers 22 and 32 are irradiated with the electromagnetic waves 24, the heating layers 22 and 32 are thus made to generate heat, whereby the to-be-transferred surfaces 23a and 33a of the to-be-transferred objects 23 and 33 made of materials which transmit the electromagnetic waves 24 are softened. Thus, the indented shapes of the indented surfaces 21a and 21b of the mold 21 are transferred to the to-be-transferred surfaces 23a and 33a of the to-be-transferred objects 23 and 33.

That is, in the imprint method according to the second mode for carrying out the present invention, the to-be-transferred objects 23 and 33 which are made of materials which transmit the electromagnetic waves 24 can be used, and thus, the imprint method (i.e., a both-side imprint method) having higher practicability can be provided. Further, in the imprint method according to the second mode for carrying out the present invention, it is possible to provide the imprint method (i.e., the both-side imprint method) which is of a high speed and has improved productivity.

Further, in the mold 21 according to the second mode for carrying out the present invention, the heating layers 22 and 32 which absorb the electromagnetic waves 24 and generate heat are formed on the indented surfaces 21a and 21b of the mold 21, the heating layers 22 and 32 are irradiated with the electromagnetic waves 24, the heating layers 22 and 32 are thus made to generate heat, whereby the to-be-transferred surfaces 23a and 33a of the to-be-transferred objects 23 and 33 are softened. Therefore, it is possible to transfer the indented shapes of the indented surfaces 21a and 21b also to the to-be-transferred surfaces 23a and 33a of the to-be-transferred objects 23 and 33 made of materials which transmit the electromagnetic waves 14.

Thus, by the first and second modes for carrying out the present invention, it is possible to solve the problems in the LADI method, and to provide an imprint method of higher practicability. Further, it is possible to provide a mold by which an imprint method of higher practicability can be achieved.

### < Example 1>

FIG. 14 depicts a schematic plan view of a mold 41 used in an example 1. FIG. 14 depicts a schematic sectional view of the mold 41 used in the example 1.

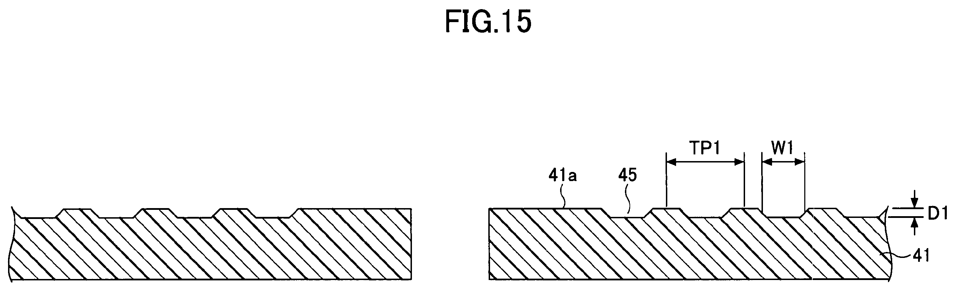

The mold 41 depicted in FIGS. 14 and 15 is a substrate which is used in a HD or DVD-RW disk, made of a polycarbonate resin, of a diameter of approximately *φ*120 mm, a thickness of approximately 0.6 mm, and a diameter of a central hole of approximately *φ*15 mm. A groove 45 (i.e., a depressed portion) of a track pitch TP1 = approximately 400 nm, a groove width W1 = approximately 200 nm, and a depth D1 = approximately 27 nm, is formed spirally on one side of the mold 41 in a range of a diameter between approximately *φ*48 and *φ*118 mm. In the embodiment 1, unless otherwise noted, a mold pattern means a spiral groove 45. A surface on which the groove 45 is formed is referred to as an indented surface 41a.

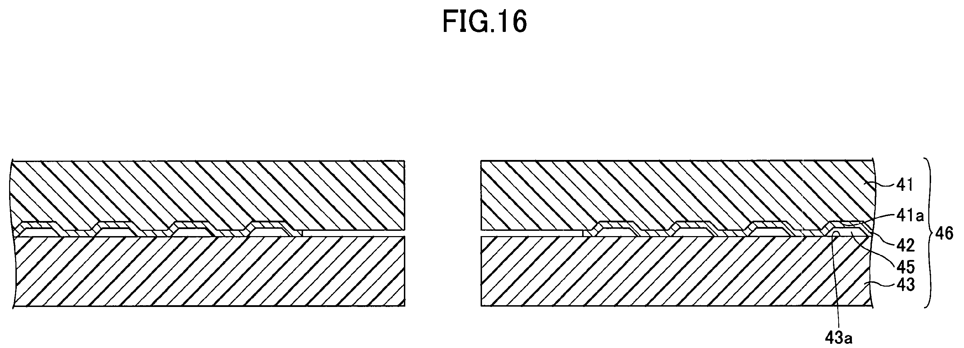

FIG. 16 illustrates a bonded sample 46. On the indented surface 41a of the mold, a Ge film (of a film thickness of approximately 10 nm) was formed in a sputtering process, as a heating layer 42. As a to-be-transferred object 43, a substrate made of a polycarbonate resin having the same outside dimensions as those of the mold 41 but having no grove 45 formed thereon was prepared. As depicted in FIG. 16, protruding portions of the heating layer 42 formed on the indented surface 41a of the mold 41 were made to come into contact with a to-be-referred surface 43a of the to-be-transferred object 43 in vacuum, they were bonded in a state in which vacuum adsorption was maintained therebetween, and thus, the bonded sample 46 was formed.

As an irradiation system to irradiate with electromagnetic waves, POP120-7A made by Hitachi Computer Peripherals Co., Ltd. was used. This irradiation system is one used for initialization of a phase-change type optical recording medium, and mounts an optical head having a semiconductor laser of a wavelength of approximately 830 nm, which is a light source of the electromagnetic waves. This optical head has an automatic focus servo mechanism, and focuses laser light emitted by the semiconductor laser as the light source, on the heating layer 42 of the bonded sample 46. A size of a focused beam is a length of approximately 75 *µ*m in a radius direction of the bonded sample 46 and a width of approximately 1 *µ*m.

An imprint method itself was, approximately the same as one for initialization of a phase-change type optical recording medium. That is, the bonded sample 46 was placed on a turn table provided in the irradiation system, the bonded sample 46 was then rotated at any rotation speed, focus servo control was carried out, and, in the stated condition, laser light was irradiated with from a side of the to-be-transfer object 43. Further, with the laser light being irradiated with, the optical head was moved in a radius direction of the bonded sample 46, and thus, the entirety of the range in which the groove 45 was formed was irradiated with the laser light.

It is noted that, during the irradiation with laser light, tracking servo control was not carried out. In the example 1, the imprint method was carried out in a setup condition depicted in Table 1. Under the condition, the imprint method may be finished within a time of approximately 40 seconds per sheet. However, in the example 1, for the purpose that a state of the imprint method can be observed, carrying out the imprint method was interrupted in the middle.

**Table 1**

| | |
|---|---|
| emitted laser power | 2000 mW |
| optical head feeding speed | 36 *µ*m/revolution |
| rotating line velocity of bonded sample 46 | 8 m/s |

After the irradiation with laser light, the mold 41 and the to-be-transferred object 43 were removed from one another. Then, when the to-be-transferred surface 43a of the to-be-transferred object 43 which had been in contact with the indented surface 41a of the mold 41 was observed visually, interference colors, caused by light interference, the same as those of the indented surface 41a of the mold 41, could be seen. In order to understand the state more easily, an Ag film of a film thickness of approximately 200 nm was formed on the to-be-transferred surface 43a of the to-be-transferred object 43. Further, for the purpose of comparison, an Ag film of a film thickness of approximately 200 nm was formed also on the indented surface 41a of the mold 41.

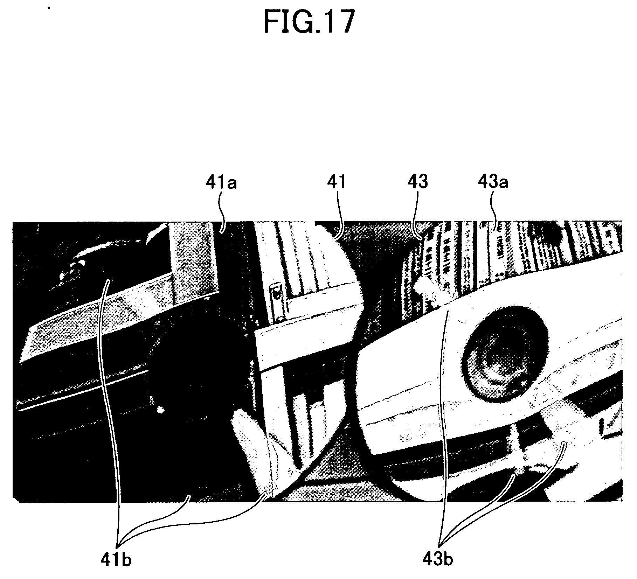

FIG. 17 depicts a view for checking interference colors of the indented surface 41a of the mold 41 and the to-be-transferred surface 43a of the to-be-transferred object 43. In FIG. 17, it is possible to see the same interference colors 41b and 43b of both indented surface 41a of the mold 41 and to-be-transferred surface 43a of the to-be-transferred object 43. Therefore, it can bee seen that, an indented shape of the indented surface 41a of the mold 41 had been transferred to the to-be-transferred surface 43a of the to-be-transferred object 43. Further, since the interference colors 43b of the to-be-transferred surface 43a of the to-be-transferred object 43 was ended at a part at which laser irradiation was ended, and no interference colors could be seen in the peripheral part, it can be seen that the above-mentioned transfer of the indented shape was carried out by means of the laser light irradiation.

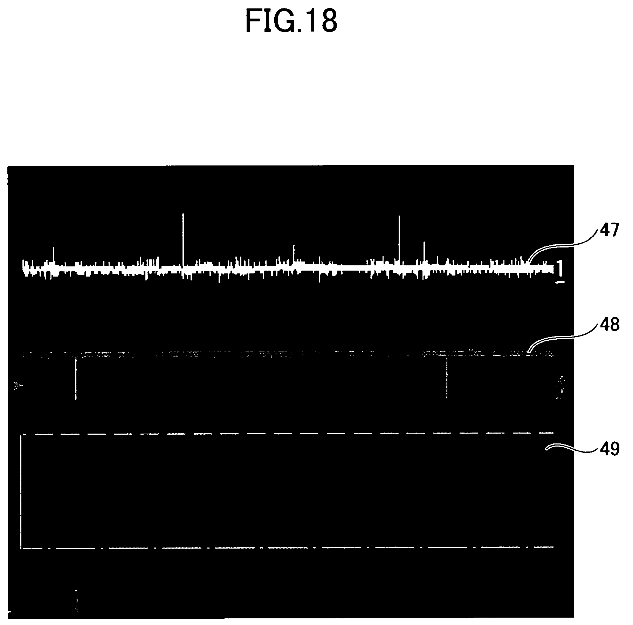

Next, an optical disk evaluation apparatus (ODU-1000 made by Pulstec Industrial Co., Ltd.) was used to check a signal of the to-be-transferred surface 43a of the to-be-transferred object 43 to which the indented shape had been transferred, when tracking was turned on and off. FIG. 18 depicts a full light quantity signal 47, a trigger signal 48 and a push-pull signal 49 when the tracking servo was tuned off. The full light quality signal 47 represents reflectance, the trigger signal 48 represents a time corresponding to one turn, and the push-pull signal 49 is used as a tracking error signal or such. Further, the abscissa represents a time and the ordinate represents a voltage. In FIG. 18, the push-pull signal 49 can be seen. Thereby, it can be seen that the indented shape of the indented surface 41a of the mold 41 had been transferred to the to-be-transferred surface 43a of the to-be-transferred object 43.

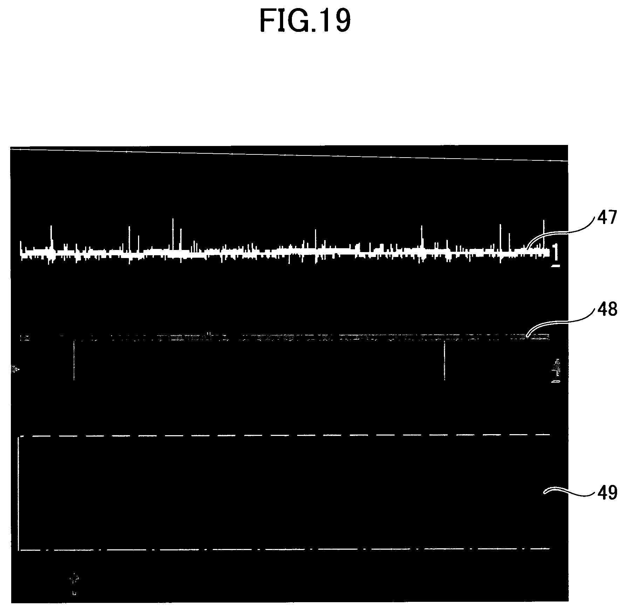

FIG. 19 depicts the full light quantity signal 47, the trigger signal 48 and the push-pull signal 49 when the tracking servo was turned on. The full light quantity signal 47 represents reflectance, the trigger signal 48 represents a time corresponding to one turn and the push-pull signal 49 is used as a tracking error signal or such. Further, the abscissa represents a time and the ordinate represents a voltage. In FIG. 19, as tracking servo could be carried out without any problem, it can be seen that the indented shape of the indented surface 41a of the mold 41 had been satisfactorily transferred to the to-be-transferred surface 43a of the to-be-transferred object 43. It is noted that, in this evaluation with the use of the optical disk evaluation apparatus, the same result could be obtained throughout the area on which laser irradiation was carried out.

The heating layer 42 which absorbs electromagnetic waves and generates heat is formed on the indented surface 41a of the mold 41, the heating layer 42 is irradiated with the electromagnetic waves, the heating layer 42 is thus made to generate heat, and thereby, the to-be-transferred surface 43a of the to-be-transferred object 43 is softened. Therefore, it is possible to transfer the indented shape to the to-be-transferred object 43 which is made of a material which transmits electromagnetic waves. Thus, it is possible to provide the imprint method having improved practicability.

### <Examples 2 through 9>

In each of examples 2 through 9, the same as in the example 1, a heating layer 42 was formed in a sputtering process on an indented surface 41 of a mold 41 depicted in FIGS. 14 and 15. First, in each of the examples 2 through 4, Ge was used as a material of the heating layer 42, and, the heating layer 42 was formed with a film thickness depicted in Table 2. Thus, the imprint method was carried out. Table 2 also depicts the results. Therefrom, it can be been seen that the film thickness of Ge has an optimum range in which the indented shape can be transferred. The reason therefor may be as follows. That is, when the film radiate heat which the Ge film has once generated.

**Table 2**

| | Ge film thickness (nm) | interference colors visually seen/or not seen | groove signal seen/or not seen with optical evaluation apparatus |
|---|---|---|---|
| Example 2 | 5 | not seen | not seen |
| Example 1 | 10 | seen | Seen |
| Example 3 | 15 | seen | seen |
| Example 4 | 20 | not seen | not seen |

Next, in each of example 5 through 9, as a material of a heating layer 42, Ag was used, and the heating layer 42 was formed with a film thickness depicted in Table 3, and thus, the imprint method was carried out. Table 3 also depicts the results. As can be seen, transfer of an indented shape could not be carried out regardless of the film thickness of Ag. The reason therefor may be as follows: Heat conductivity of Ag itself may be too high to generate a sufficient heat amount for transferring the indented shape.

In Tables 2 and 3, the film thickness was measured with the use of a spectroscopic ellipsometer (M2000DI made by JA. Woollam). Further, whether a groove signal could be seen with the optical evaluation apparatus was determined from whether the push-pull signal could be seen when the tracking servo is turned off depicted in FIG. 18.

**Table 3**

| | Ag film thickness (nm) | interference colors visually seen/or not seen | groove signal seen/or not seen with optical evaluation apparatus |
|---|---|---|---|
| Example 5 | 2 | not seen | not seen |
| Example 6 | 5 | not seen | not seen |
| Example 7 | 10 | not seen | not seen |
| Example 8 | 15 | not seen | not seen |
| Example 9 | 20 | not seen | not seen |

The results of Tables 2 and 3 show that it is very important to adjust a required heat amount to be generated for transferring an indented shape, by a laser light absorbing amount and heat conductivity of the material of the heating layer 42 and a film thickness of the heating layer 42. Such contents could not be found in the related art.

The heating layer 42 which absorbs electromagnetic waves and generates heat is formed on the indented surface 41a of the mold 41, the heating layer 42 is irradiated with electromagnetic waves, the heating layer 42 is thus made to generate heat, and thereby, the to-be-transferred surface 43a of the to-be-transferred object 43 is softened. Therefore, it is possible to transfer the indented shape to the to-be-transferred object 43 which is made of a material which transmits electromagnetic waves. Thus, it is possible to provide the imprint method having improved practicability.

### <Example 10>

In the example 10 10, a heating layer 42 was formed in a sputtering process on an indented surface 41a of a mold 51 depicted in FIGS. 14 and 15. The same as in the examples 1 through 4, Ge was used as a material of the heating layer 42. A film of the heating layer 42 with a film thickness of each of the four film thicknesses depicted in Table 2 was formed, and thus, the imprint method was carried out on each of the four samples. In the example 10, irradiation with laser light was carried out not from the side of the to-be-transferred object 43 but from the side of the mold 41. As a result, results the same as those of the examples 1 through 4 depicted in Table 2 were obtained. Therefrom, it can be seen that, it is possible to satisfactorily transfer an indented shape regardless of a direction in which laser light is irradiated with.

The heating layer 42 which absorbs electromagnetic waves and generates heat is formed on the indented surface 41a of the mold 41, the heating layer 42 is irradiated with electromagnetic waves, the heating layer 42 is thus made to generate heat, and thereby, the to-be-transferred surface 43a of the to-be-transferred object 43 is softened. Therefore, when both the mold 41 and the to-be-transferred object 43 are made of materials which transmits electromagnetic waves, it is possible to transfer an indented shape to the to-be-transferred object 43 when electromagnetic waves are irradiated with either through the mold 41 or through the to-be-transferred object 43. Thus, it is possible to provide the imprint method having improved practicability.

### <Example 11>

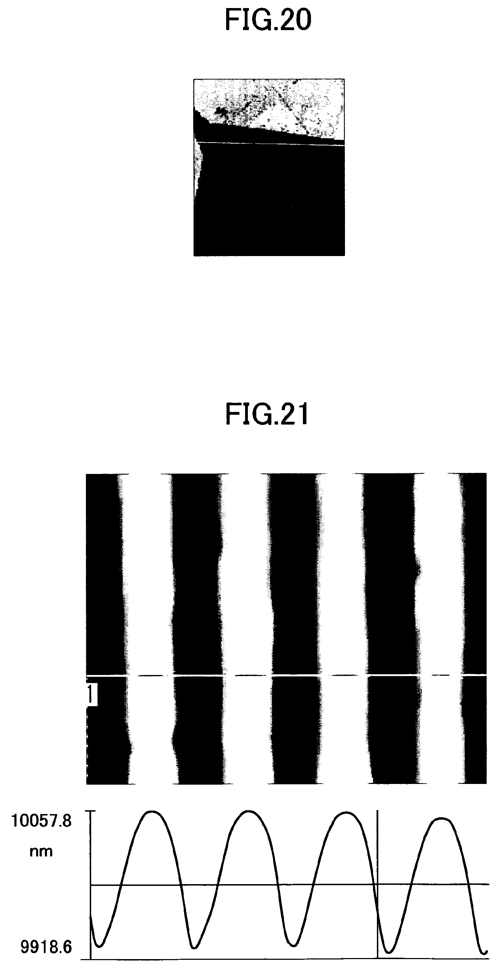

In an example 11, as a mold 51, a commercially available hologram sheet was used, and a both-side imprint method was carried out. FIG. 20 depicts a photomicrograph of the hologram sheet used as the mold 51. The hologram sheet of the mold 51 is a thin sheet of a rectangular parallelepiped having outside dimensions of 25 mm by 20 mm by 0.1 mm. FIG. 21 depicts an AFM image depicting an indented state of the hologram sheet of the mold 51, and evaluation was carried out with the use of an AFM apparatus (VN-8000 made by KEYENCE CORPORATION). From evaluation of the AFM image depicted in FIG. 21, it can be seen that the hologram sheet of the mold 51 has an indented shape of a height of approximately 130 nm and a pitch of approximately 800 nm (a surface having the indented shape of the hologram sheet of the mold 51 will be referred to as an "indented surface 51a", hereinafter).

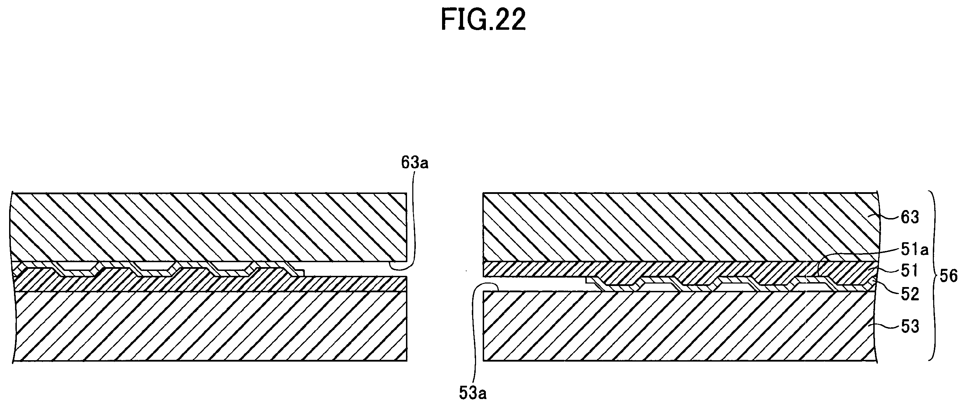

FIG. 22 illustrates a bonded sample 56. Two sheets of the molds 51 were prepared, and a Ge film (having a film thickness of approximately 10 nm) was formed in a sputtering process as a heating layer 52 on an indented surface 51a of each mold 51. As each of to-be-transferred objects 53 and 63, a substrate made of a polycarbonate resin on which no groove 45 was formed, having outside dimensions the same as those of the mold 41 depicted in FIG. 14, was prepared. As depicted in FIG. 22, in a condition in which, the heating layer 52 formed on the indented surface 51a of the first mold 51 faces upward and the heating layer 52 formed on the indented surface 51a of the second mold 51 faces downward, and, in vacuum, with the two molds 51 being made not to overlap one another, protruding portions of the first heating layer 52 and the to-be-transferred surface 53a of the to-be-transferred object 53 were made to come into contact, protruding portions of the second heating layer 52 and the to-be-transferred surface 63a of the to-be-transferred object 63 were made to come into contact. Thus, bonding was carried out in a state in which vacuum adsorption was maintained between the respective members, and a bonded sample 56 was formed.

The thus-formed bonded sample 56 was irradiated with laser light, in the same procedure as that in the example 1. However, there was a part in which no mold 51 exists between the to-be-transferred objects 53 and 63 because of a relationship of dimensions between the molds 51 and the to-be-transferred objects 53 and 63. Therefore, when an automatic focusing mechanism is used, an apparatus stops at the part at winch the mold 51 does not exist. For this reason, a fixed focus method was used. A setup condition depicted in Table 4 was used.

**Table 4**

| | |
|---|---|
| emitted laser power | 2200 mW |
| optical head feeding speed | 36 *µ*m/revolution |
| rotating line velocity of bonded sample 56 (m/s) | 4 m/s |

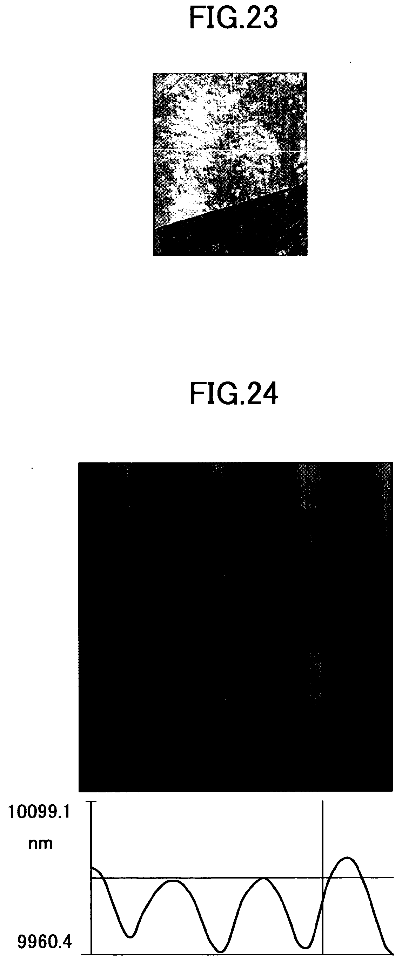

Laser light was irradiated with, side by side, then, the to-be-transferred objects 53 and 63 were removed, and the to-be-transferred surfaces 53a and 63a of the to-be-transferred objects 53 and 63, which had been in contact with the molds 51, were visually observed. As a result, interference colors, caused by light interference, the same as those of the molds 51, could be seen. FIG. 23 is a photomicrograph of the to-be-transferred surface 53a of the to-be-transferred object 53. FIG. 24 depicts an AFM image depicting a state of the to-be-transferred surface 53a of the to-be-transferred object 53, and evaluation was carried out whit the use of an AFM apparatus (VN-8000 made by KEYENCE CORPORATION). From evaluation with the use of the AFM apparatus, it could be confirmed that the to-be-transferred surface 53a of the to-be-transferred object 53 had an indented shape of a height of approximately 70 nm and a pitch of approximately 820 nm. In the same method, it could be confirmed that, also the to-be-transferred surface 63a of the to-be-transferred object 63 had the same indented shape as that of the to-be-transferred surface 53a of the to-be-transferred object 53.

Except that the indented shape thus transferred to each of the to-be-transferred surfaces 53a and 63a of the to-be-transferred objects 53 and 63 has the height approximately on the order of half of the indented shapes of the indented surfaces 51a of the hologram sheets of the molds 51, the indented shapes of the molds 51 were satisfactorily transferred to the to-be-transferred surfaces 53a and 63a of the to-be-transferred objects 53 and 63. A cause of the height becoming approximately on the order of half may be that, because focusing of laser light was carried out in the fixed focusing method, focusing might not be carried out sufficiently, and thereby, a sufficient heat amount might not be generated.

In the example 11, as mentioned above, as depicted in FIG. 22, in a condition in which, the heating layer 52 formed on the indented surface 51a of the first mold 51 faces upward and the heating layer 52 formed on the indented surface 51a of the second mold 51 faces downward, and, in vacuum, with the two molds 51 being made not to overlap one another, the to-be-transferred objects 53 and 63 and the molds 51 are overlaid in such a condition that the molds 51 are inserted between the to-be-transferred objects 53 and 63. Thus, bonding was carried out in a state in which vacuum adsorption was maintained, and a bonded sample 56 was formed. However, from the result of the example 11, it can easily be imagined that, a both-side imprint method described above as the second mode for carrying out the present invention can be realized, in which, a mold having indented surfaces on both sides is used, the mold is inserted between two to-be-transferred objects made of materials which transmit electromagnetic waves, and the two to-be-transferred objects are irradiated with the electromagnetic waves.

According to the present invention, the both-side imprint method can be achieved, and thus, it is possible to provide an imprint method having higher practicability. Further, according to the present invention, it is possible to provide an imprint method having high speed and improved productivity.

### <Third Mode for Carrying out the Present Invention>

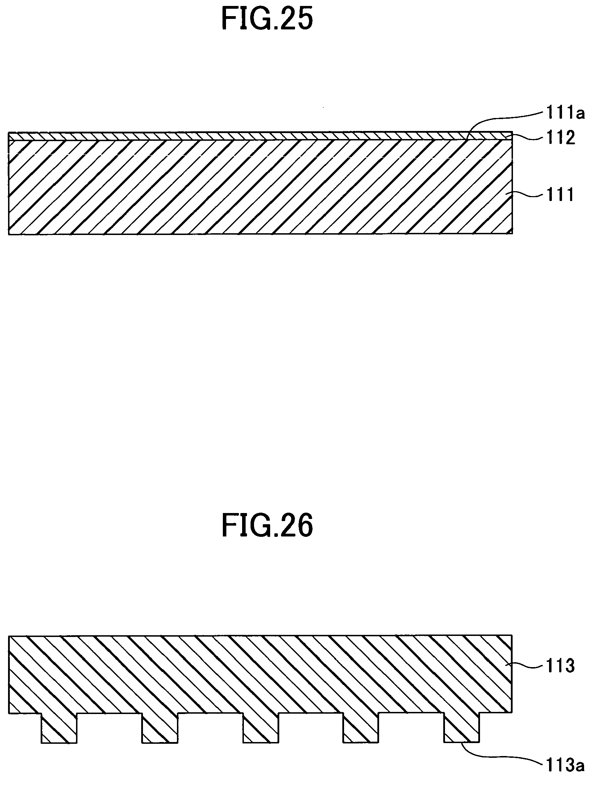

With reference to FIGS. 25-31, an imprint method according to a third mode for carrying out the present invention will be described. FIGS. 25-31 schematically illustrate the imprint method according to the third mode for carrying out the present invention. In FIGS. 25-31, 111 represents a to-be-transferred object, 112 represents a heating layer, 113 represents a mold, and 114 represents electromagnetic waves. Further, 111a represents a to-be-transferred surface of the to-be-transferred object 111, and 113a represents an indented surface of the mold 113.

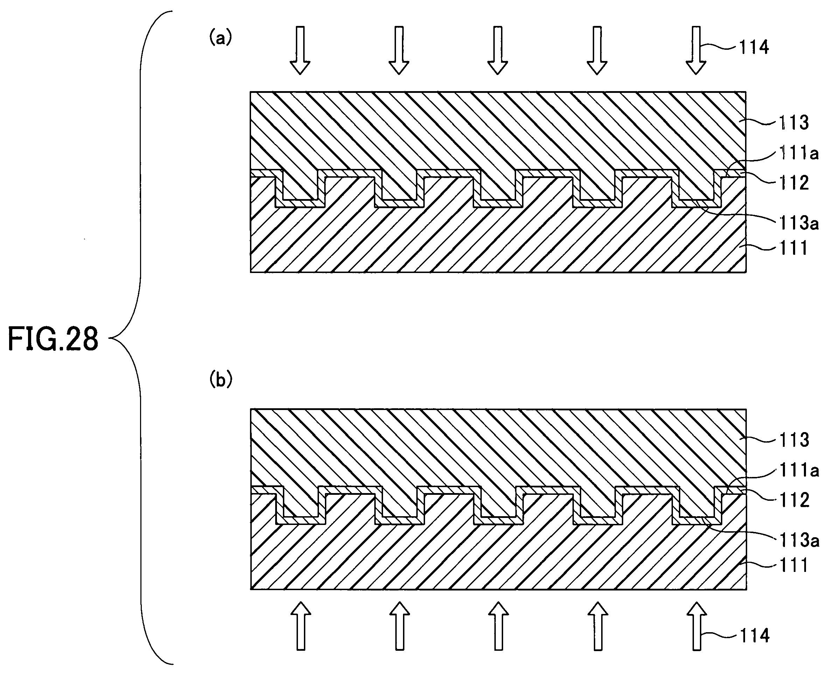

First, in a process depicted in FIG. 25, i.e., a heating layer forming process, the to-be-transferred object 111 is prepared, and the heating layer 112 is formed on the to-be-transferred surface 111a of the to-be-transferred object 111. As a material of the to-be-transferred object 111, for example, a resin typified by a polycarbonate resin, an acrylic resin, an epoxy resin, a polystyrene resin, an acrylonitrile-styrene copolymer, a polyethylene resin, a polypropylene resin, a silicone resin, a fluorine resin, a ABS resin, a urethane resin or such, a crystal or ceramics material of an oxide typified by SiO₂, Al₂O₃ or such, a nitride typified by SiN, AlN or such, a carbide typified by SiC, GC (i.e., glassy carbon) or such, or a material used as a so-called substrate such as Si or such, may be used. The heating layer 112 is made of a heating material which, in a process depicted in FIG. 28 later, absorbs the electromagnetic waves 114 which are irradiated with through the to-be-transferred object 111 or the mold 113, which is made of a material which transmits the electromagnetic waves 114, and generates such a heat amount to be able to soften the to-be-transferred surface 111a of the to-be-transferred object 111.

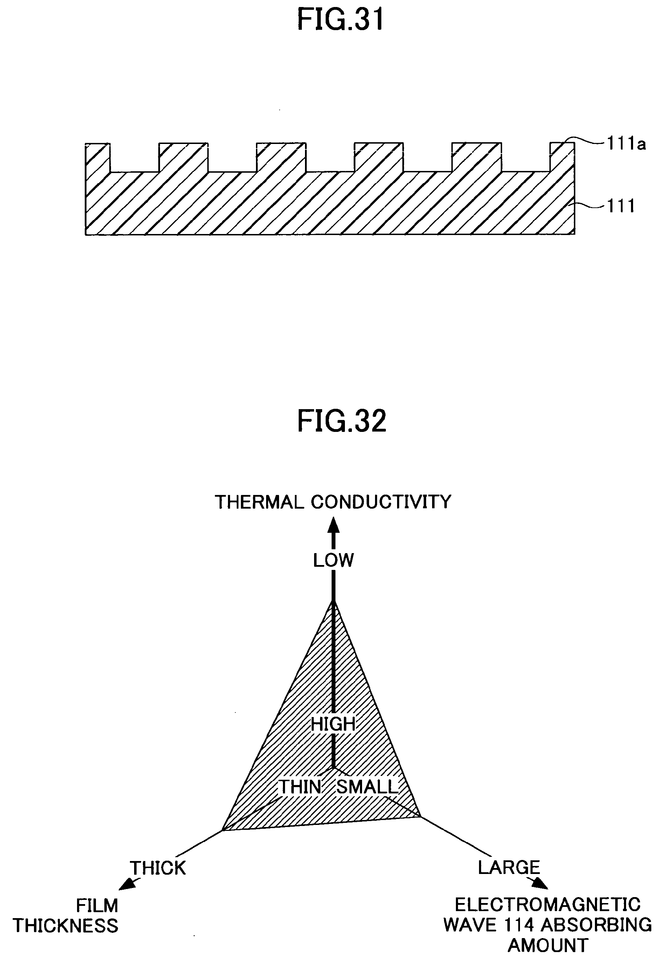

The heat amount generated by the heating layer 112 is adjusted by means of an electromagnetic wave 114 absorbing amount and heat conductivity of the material of the heating layer 112 and a film thickness of the heating layer 112. FIG. 32 schematically illustrates a relationship between the electromagnetic wave 114 absorbing amount, the heat conductivity and the film thickness of the heating layer 112, and the heat amount generated by the heating layer 112. In FIG. 32, an area of an oblique line part defined by a triangle corresponds to the heat amount. By optimizing a balance between the electromagnetic wave 114 absorbing amount, the heat conductivity and the film thickness of the heating layer 112 with respect to the to-be-transferred object 111 to which the indented pattern of the indented surface 1113a is transferred, it is possible to carry out transferring an indented shape of the indented surface 113a satisfactorily.

For example, a material having predetermined electromagnetic wave 114 absorbing amount and predetermined heat conductivity is selected, and an optimum film thickness of the heating layer 112 is determined, such that the heating layer 112 generates the necessary heat amount, in consideration of the predetermined electromagnetic wave 114 absorbing amount and the predetermined heat conductivity. The absorbing amount and heat conductivity may preferably fall within respective ranges of, for example, 50 through 100 % and 20 through 400 W/m/k.

As a material of the heating layer 112, a material, which has satisfactory releasability from the to-be-transferred object 111 and also, generates heat in the same degree also when irradiation with the electromagnetic waves 114 is carried out a plurality of times, is preferable. Specifically, any one of Si and Ge which are semiconductors, Sn, Sb and Bi which are semimetals, Cu, Au, Pt and Pd which are precious metals, and so forth, Zn, Ni, Co and Cr which are transition metals, and alloys thereof, carbides typified by SiC, TiC and so forth, a ceramics material such as an oxygen deficiency oxide typified by SiOx, GeOx and so forth, and compounds or complexes thereof, is preferable. Further, it is preferable that a material of the heating layer 112 includes a phase change material. Since the phase change material has large electromagnetic wave 114 absorbing amount and heat conductivity, it is possible to reduce an optimum film thickness of the heating layer 112 to generate the necessary heat amount, and thus, it is possible to improve productivity.

As the phase change material, a material may be appropriately selected from materials used as a material of a recording layer of a rewritable-type optical recording medium. For example, it is preferable to use a material which includes one or more elements selected from Sb, Ge, Ga, In, Zn, Mn, Sn, Ag, Mg, Ca, Ag, Bi, Se and Te. As the phase change material, a desired material may be used in consideration of a thermal characteristic and an optical chrematistic. A GeSbTe alloy, an AgInSbTe alloy, an AgInSbTeGe alloy, a GaSbSnGe alloy, GeSbSnMn alloy, a GeInSbTe alloy, a GeSbSnTe alloy and so forth, are preferable.

Further, the heating layer 112 has a configuration of not only a single layer but plurality of layers which are laminated together. By using such a configuration of a plurality of layers, which is referred to as a multi-layer configuration, it is possible to adjust not only a heating amount but also temperature maintaining, a cooling speed and so forth. Thus, it is possible to carry out the imprint method satisfactorily.

Next, in a process depicted in FIG. 26, i.e., a mold forming process, the mold 113 having the indented surface 113a is formed. The indented surface 113a is a surface including a nanometer-scale indented pattern for example. As a material of the mold 113, for example, a molding material or such commonly used for a nanoimprint method may be used, for example, a resin typified by a polycarbonate resin, an acrylic resin, an epoxy resin, a polystyrene resin, an acrylonitrile-styrene copolymer, a polyethylene resin, a polypropylene resin, a silicone resin, a fluorine resin, a ABS resin, a urethane resin or such, a crystal or ceramics material of an oxide typified by SiO₂, Al₂O₃ or such, a nitride typified by SiN, AlN or such, a carbide typified by SiC, GC (i.e., glassy carbon) or such, or a metal material typified by Ni, Ta, or such, may be used. The indented surface 113a of the mold 113 can be formed by means of an FIB (i.e., Focused Ion Beam) process or such. The FIB process is such that, as well-known, a Ga (i.e., gallium) ion beam which is sufficiently narrowed is used, and a complicate shape can be formed with an accuracy of a submicron level.

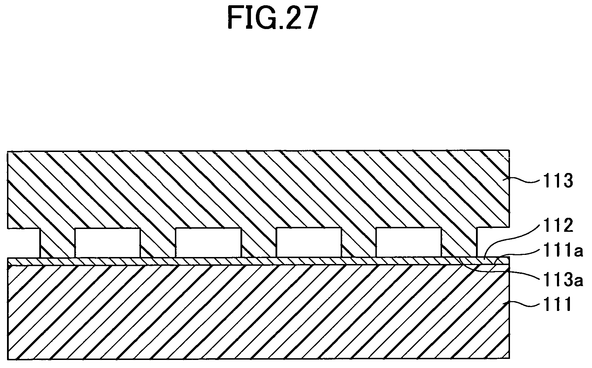

Next, in a process of FIG. 27, the heating layer 112 formed on the to-be-transferred surface 111a of the to-be-transferred object 111 and protruding portions of the indented surface 113a of the mold 113 are made to come into contact with one another. The above-mentioned to come in contact with is carried out in such a manner that the to-be-transferred object 111 and the mold 113 are pressed to one another strongly by an external pressure. Specifically, a special pressing machine may be used to press by mechanical force. However, it is preferable to use a vacuum adsorption method in which a vacuum is formed between the heating layer 112 and the indented surface 113a of the mold 113, and thus, an external atmospheric pressure is used to press the heating layer 12 and the indented surface 113a of the mold 113 to each other.

The vacuum adsorption method can be carried out with the use of a general-purpose apparatus, and it is easy to maintain the adsorption state. Further, even when the to-be-transferred object 111 or the mold 113 does not have a high mechanical strength, it is possible to obtain such a pressing force which is minimum so that the to-be-transferred object 111 and the mold 113 are prevented from being broken. By using vacuum adsorption, it is possible to carry out the imprint method satisfactorily. Vacuum adsorption can be carried out with the use of an existing vacuum bonding machine which is one used to bond two substrates for forming a DVD-ROM which is a well-known optical recording medium in a vacuum state in which no gas which may cause voids exists.

Next, in a process of FIG. 28, i.e., a softening process, the heating layer 112 is irradiated with the electromagnetic waves 114 through the to-be-transferred object 111 or the mold 113, which is made of a material which transmits the electromagnetic waves 114. Thereby, the heating layer 112 is made to generate heat, and therewith, the to-be-transferred surface 111a of the to-be-transferred object 111 is softened. The to-be-transferred object 111 and the mold 113 are strongly pressed to one another through the heating layer 112, for example, by means of vacuum adsorption as mentioned above. Therefore, when the to-be-transferred surface 111a of the to-be-transferred object 111 is thus softened as a result of the heating layer 112 generating heat by means of the electromagnetic waves 114 being irradiated with, the to-be-transferred surface 111a of the to-be-transferred object 111 changes in its shape according to an indented shape of the indented surface 113a of the mold 113. It is noted that, a melting point or a softening point of the material of the mold 113 is equal to or higher than a melting point or a softening point of the material of the to-be-transferred object 111.

At least any one of the to-be-transferred object 111 and the mold 113 should be made of a material which transmits the electromagnetic waves 114. When the mold 113 is made of a material which transmits the electromagnetic waves 114, as depicted in FIG. 28, (a), the heating layer 112 is irradiated with the electromagnetic waves 114 through the mold 113. When the to-be-transferred object 111 is made of a material which transmits the electromagnetic waves 114, as depicted in FIG. 28, (b), the heating layer 112 is irradiated with the electromagnetic waves 114 through the to-be-transferred object 111.

Further, when both the to-be-transferred object 111 and the mold 113 are made of materials which transmit the electromagnetic waves 114, either the heating layer 112 may be irradiated with the electromagnetic waves 114 through the mold 113 as depicted in FIG. 28, (a) or the heating layer 112 may be irradiated with the electromagnetic waves 114 through the to-be-transferred object 111 as depicted in FIG. 28, (b). However, it is preferable that the heating layer 112 is irradiated with the electromagnetic waves 114 through the to-be-transferred object 111 as depicted in FIG. 28, (b).

This is because, when the heating layer 112 is irradiated with the electromagnetic waves 114 through the mold 113, interference may occur in the electromagnetic waves because of the indented shape of the indented surface 113a of the mold 113. When interference occurs, the heating layer 12 may not be uniformly irradiated with the electromagnetic waves 114, and thereby, accuracy of an indented shape transferred to the to-be-transferred surface 111a of the to-be-referred object 111 may degrade. On the other hand, when the heating layer 112 is irradiated with the electromagnetic waves 114 through the to-be-transferred object 111, the to-be-transferred surface 111a is flat until the heating layer 112 generates heat and the to-be-transferred surface 111a of the to-be-transferred object 111 is softened thereby. As a result, the above-mentioned problem does not occur.

A wavelength of the electromagnetic waves 114 may be preferably equal to or shorter than 2000 nm. When a wavelength is longer than 2000 nm, there are few heating materials which sufficiently absorb the electromagnetic waves 114. Laser light is most preferable as the electromagnetic waves 114. This is because, when laser light is used, it is possible to increase light intensity per unit area, i.e., energy density, on the heating layer 112. Further, as a laser which emits laser light, a semiconductor laser is especially preferable. In fact, the semiconductor laser is small-sized, can be easily maintained, is inexpensive and has a long life.

In the softening process depicted in FIG. 28, it is preferable to carry out a focusing process in which the electromagnetic waves 114 emitted by a light source are focused on the hearting layer 112. By carrying out the focusing process, it is possible to efficiently carry out irradiation with the electromagnetic waves 114. Further, it is preferable to carry out focus servo control in the focusing process when the imprint method is carried out in such a manner that an optical head (not depicted) having the light source which emits the electromagnetic waves 114, or the to-be-transferred object 111 and the mold 113, or both, is two-dimensionally moved. By carrying out the focus servo control, it is possible to cancel mechanical errors and positively focus the electromagnetic waves 14 on the heating layer 112. Thus, it is possible to carry out the imprint method satisfactorily.

The above-mentioned case where the imprint method is carried out in such a manner that an optical head (not depicted) having the light source which emits the electromagnetic waves 114, or the to-be-transferred object 111 and the mold 113, or both, is two-dimensionally moved, will now be described. Such a case is a case where, for example, in an example 12 described later or such, the electromagnetic waves 114 are irradiated with, while, the to-be-transferred object 111 and the mold 113 which are pressed to one another by means of vacuum adsorption are placed on a turn table and are rotated. The focus servo may be carried out in a well-known method which is one used when laser light is made to follow and is focused on a rotated optical recording medium when information is recorded to or reproduced from the optical recording medium.

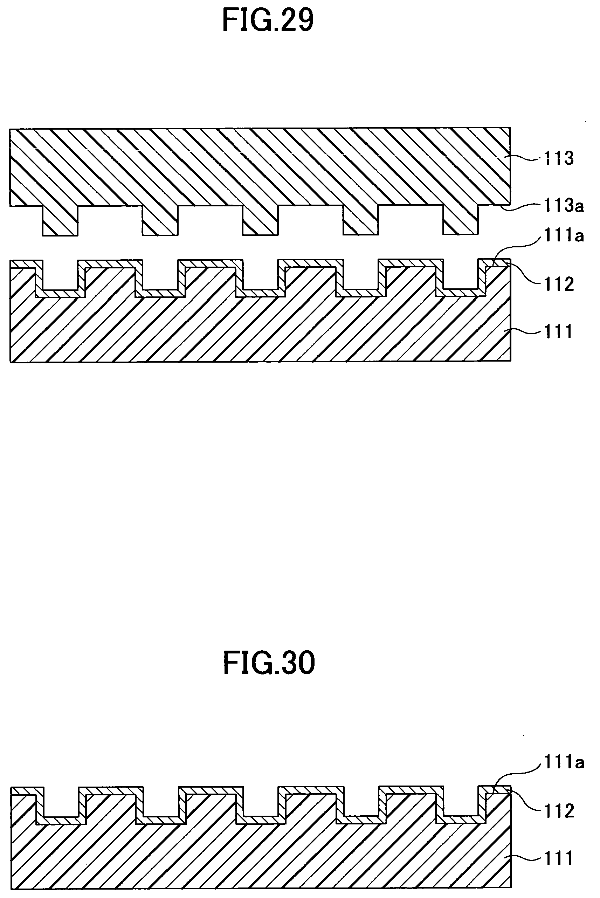

Next, in a process, i.e., a releasing process, as depicted in FIG. 29, the mold 113 is released from the to-be-transferred object 111. Next, in a heating layer removing process, as depicted in FIG. 30, the heating layer 112 formed on the to-be-transferred surface 111a of the to-be-transferred object 111 is removed. As a result, as depicted in FIG. 31, the indented shape of the indented surface 113a of the mold 113 is transferred to the to-be-transferred surface 111a of the to-be-transferred object 111. It is noted that, the heating layer 112 can be removed by means of, for example, wet etching. The wet etching means etching using a liquid chemical which has such a characteristic to corrode and dissolve a target metal or such.

In an imprint method in the related art, a to-be-transferred surface of a to-be-transferred object made of a material which does not transmit electromagnetic waves is irradiated with the electromagnetic waves through a mold which transmits the electromagnetic waves. Thus, the to-be-transferred surface of the to-be-transferred object is softened, and an indented shape of an indented surface of the mold is transferred to the to-be-transferred surface of the to-be-transferred object. That is, in the related art, a material of the mold is limited to a material which transmits the electromagnetic waves, and a material of the to-be-transferred object is limited to a material which does not transmit the electromagnetic waves (i.e., a material which absorbs the electromagnetic waves and generates heat).

In contrast thereto, in the imprint method according to the third mode for carrying out the present invention, the heating layer 112 which absorbs the electromagnetic waves 14 and generates heat is formed on the to-be-referred surface 111a of the to-be-transferred object 111, the heating layer 112 is irradiated with the electromagnetic waves 114, the heating layer 112 is thus made to generate heat, whereby the to-be-transferred surface 111a of the to-be-transferred object 111 is softened. Therefore, at least any one of the to-be-transferred object 111 and the mold 113 should be made of a material which transmits the electromagnetic waves 114.

That is, in the imprint method according to the third mode for carrying out the present invention, not only a combination of a mold made of a material which transmits electromagnetic waves and a to-be-transferred object made of a material which does not transmit the electromagnetic waves used in the imprint method in the related art, but also another combination of a mold made of a material which does not transmit electromagnetic waves and a to-be-transferred object made of a material which transmits the electromagnetic waves, may be used. Also, further another combination of a mold made of a material which transmits electromagnetic waves and a to-be-transferred object made of a material which transmits the electromagnetic waves, may be used. Thus, it is possible to provide an imprint method which has highly practicability.

### <Fourth Mode for Carrying out the Present Invention>

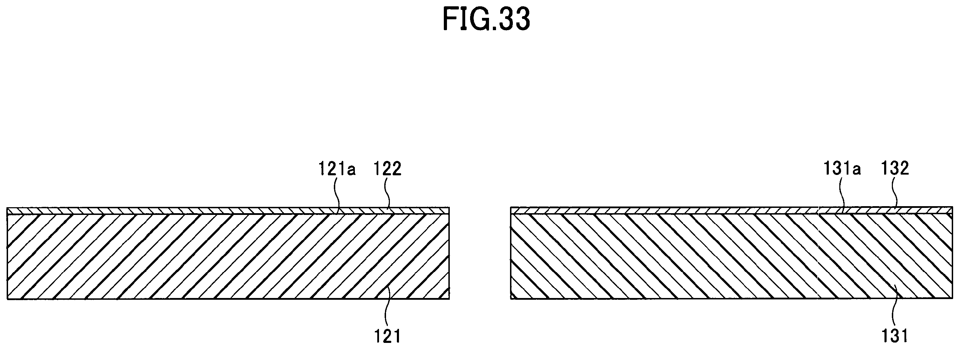

With reference to FIGS. 33 through 39, an imprint method in a fourth mode for carrying out the present invention will be described. The imprint method in the fourth mode for carrying out the present invention is different from the imprint method in the third mode for carrying out the present invention in that, in the fourth mode for carrying out the present invention, a mold having two indented surfaces is used, and indented shapes of the two indented surfaces are transferred to to-be-transferred surfaces of two to-be-transferred objects, respectively.

FIGS. 33-39 schematically illustrate the imprint method according to the fourth mode for carrying out the present invention. In FIGS. 33-37, 121 and 131 represent to-be-transferred objects, 122 and 132 represent heating layers, 123 represents a mold and 124 represents electromagnetic waves. Further, 121a and 131a represent to-be-transferred surfaces of the to-be-transferred objects 121 and 131, and 123a and 123b represent indented surfaces of the mold 123.

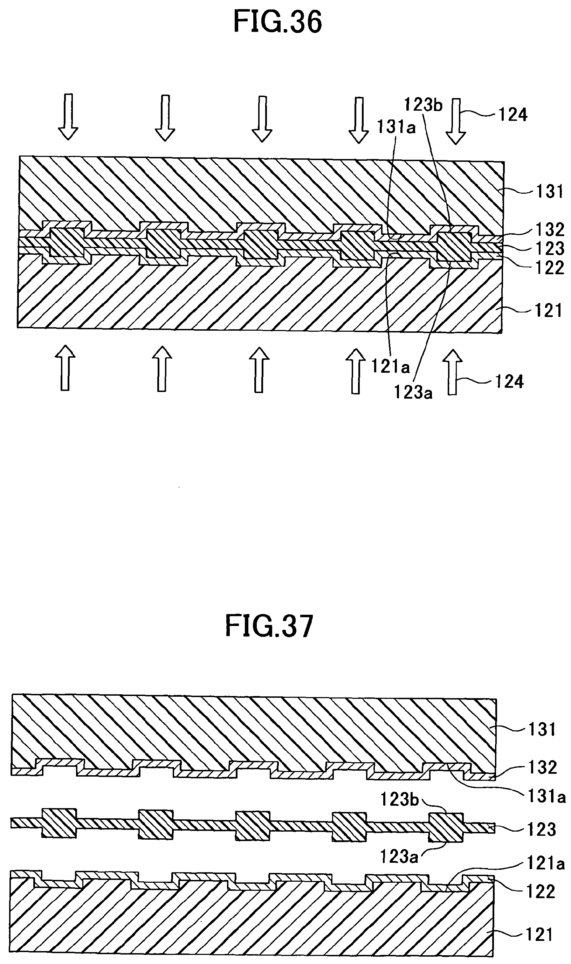

First, in a process depicted in FIG. 33, i.e., a heating layer forming process, the to-be-transferred objects 121 and 131 are prepared, and the heating layers 122 and 132 are formed on the to-be-transferred surfaces 121a and 131a of the to-be-transferred objects 121 and 131, respectively. As materials of the to-be-transferred objects 121 and 131, for example, a resin typified by a polycarbonate resin, an acrylic resin, an epoxy resin, a polystyrene resin, an acrylonitrile-styrene copolymer, a polyethylene resin, a polypropylene resin, a silicone resin, a fluorine resin, a ABS resin, a urethane resin or such, a crystal or ceramics material of an oxide typified by SiO₂, Al₂O₃ or such, a nitride typified by SiN, AlN or such, a carbide typified by SiC, GC (i.e., glassy carbon) or such, or a material which is used as a so-called substrate, such as Si, may be used. The heating layers 122 and 132 are made of a heating material which, in a process depicted in FIG. 36 later, absorb electromagnetic waves 124 which are irradiated with through the to-be-transferred objects 121 and 131, which are made of materials which transmit the electromagnetic waves 124, and generate such heat amounts to be able to soften the to-be-transferred surfaces 121a and 131a of the to-be-transferred objects 121 and 131, respectively. Adjustment of heat amounts to be generated by the heating layers 122 and 132, materials of the heating layers 122 and 132, and so forth, are the same as those of the heating layer 112 used in the imprint method according to the third mode for carrying out the present invention, and thus, duplicate description will be omitted.

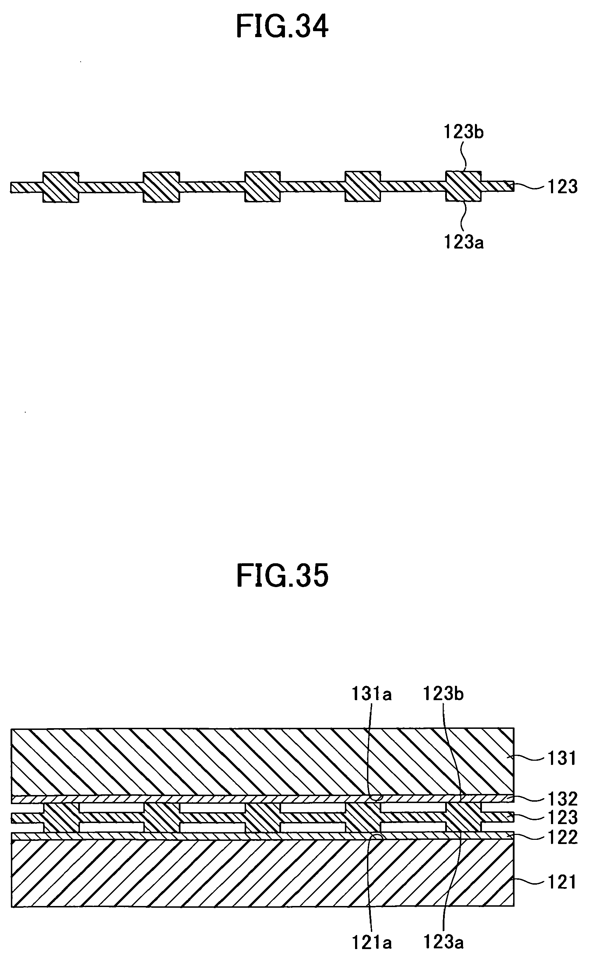

Next, in a mold forming process, as depicted in FIG. 34, the mold 123 having the indented surfaces 123a and 123b is formed. The indented surfaces 123a and 123b are surfaces including nanometer-scale indented patterns for example. As a material of the mold 123, for example, a molding material or such commonly used for a nanoimprint method may be used, for example, a resin typified by a polycarbonate resin, an acrylic resin, an epoxy resin, a polystyrene resin, an acrylonitrile-styrene copolymer, a polyethylene resin, a polypropylene resin, a silicone resin, a fluorine resin, a ABS resin, a urethane resin or such, a crystal or ceramics material of an oxide typified by SiO₂, Al₂O₃ or such, a nitride typified by SiN, AlN or such, a carbide typified by SiC, GC (i.e., glassy carbon) or such, or a metal material typified by Ni, Ta or such, may be used. A material having a form of a film is especially preferable. The indented surfaces 123a and 123b of the mold 123 can be formed by means of an FIB (i.e., Focused Ion Beam) process or such. The FIB process is such that, as well-known, a Ga (i.e., gallium) ion beam which is sufficiently narrowed is used, and a complicate shape can be formed with an accuracy of a submicron level.

Next, as depicted in FIG. 35, the heating layers 122 and 132 formed on the to-be-transferred surfaces 121a and 131a of the to-be-transferred objects 121 and 131, are made to come into contact with the protruding portions of the indented surfaces 123a and 123b of the mold 123, respectively. The above-mentioned to come in contact with is carried out in such a manner that the mold 123 and each of the to-be-transferred objects 121 and 131 are pressed to one another strongly by an external pressure. Specifically, a special pressing machine may be used to press by mechanical force. However, it is preferable to use a vacuum adsorption method in which a vacuum is formed between each of the heating layers 122 and 132 and the respective one of the indented surfaces 123a and 123b of the mold 123, and thus, an external atmospheric pressure is used to press the heating layers 122 and 132 and the indented surfaces 123a and 123b of the mold 123, respectively. Because the vacuum adsorption is the same as that used in the imprint method according to the third mode for carrying out the present invention, duplicate description will be omitted.

Next, in a process of FIG. 36, i.e., a softening process, each of the heating layers 122 and 132 is irradiated with the electromagnetic waves 24 through the respective one of the to-be-transferred objects 121 and 131, which are made of materials which transmit the electromagnetic waves 124. Thereby, the heating layers 122 and 132 are made to generate heat, and therewith, the to-be-transferred surfaces 121a and 131a of the to-be-transferred objects 121 and 131 are softened. The mold 123 and each of the to-be-transferred objects 121 and 131 are strongly pressed to one another through the respective one of the heating layers 122 and 132, for example, by means of vacuum adsorption. Therefore, when the to-be-transferred surfaces 121a and 131a of the to-be-transferred objects 121 and 131 are thus softened as a result of the heating layers 122 and 132 generating heat by means of the electromagnetic waves 124 being irradiated with, the to-be-transferred surfaces 121a and 131a of the to-be-transferred objects 121 and 131 change in their shapes according to indented shapes of the indented surfaces 123a and 123b of the mold 123. It is noted that, a melting point or a softening point of the material of the mold 123 is equal to or higher than a melting point or a softening point of the material of each of the to-be-transferred objects 121 and 131.

Both to-be-transferred objects 121 and 131 should be made of materials which transmit the electromagnetic waves 124. The heating layers 122 and 132 may be irradiated with the electromagnetic waves 124 through the to-be-transferred objects 121 and 131 one by one in sequence. However, by irradiating the heating layers 122 and 132 with the electromagnetic waves 124 from both sides of the to-be-transferred objects 121 and 131 simultaneously, productivity can be improved. As a wavelength of the electromagnetic waves 124 and so forth are the same as those in the case of the imprint method according to the third mode for carrying out the present invention, duplicate description will be omitted.

In the softening process depicted in FIG. 36, it is preferable to carry out a focusing process in which the electromagnetic waves 124 emitted by a light source are focused on the hearting layers 122 and 132. By carrying out the focusing process, it is possible to efficiently carry out irradiation with the electromagnetic waves 124. Further, it is preferable to carry out focus servo control in the focusing process when the imprint method is carried out in such a manner that an optical head (not depicted) having the light source which emits the electromagnetic waves 124, or the mold 123 and the to-be-transferred objects 121 and 131, or both, are two-dimensionally moved. By carrying out the focus servo control, it is possible to cancel mechanical errors and positively focus the electromagnetic waves 124 on the heating layers 122 and 132. Thus, it is possible to carry out the imprint method satisfactorily.

The above-mentioned case where the imprint method is carried out in such a manner that an optical head (not depicted) having the light source which emits the electromagnetic waves 124, or the mold 123 and the to-be-transferred objects 121 and 131, or both, are two-dimensionally moved, will now be described. Such a case is a case where, for example, in the embodiment 12 described later or such, the electromagnetic waves 124 are irradiated with, while, the mold 123 and each of the to-be-transferred objects 121 and 131 which are pressed to one another by means of vacuum adsorption are placed on a turn table and are rotated. The focus servo may be carried out in a well-known method which is one used when laser light is made to follow and is focused on a rotated optical recording medium when information is recorded to or reproduced from the optical recording medium.

It is noted that, in a case where the electromagnetic waves 124 are irradiated with from both sides of the to-be-transferred objects 121 and 131 simultaneously, while, the mold 123 and each of the to-be-transferred objects 121 and 131 which are pressed to one another by means of vacuum adsorption are placed on a turn table and are rotated, a mechanism which is different from an information recording/reforming apparatus in the prior art is required, such that, for example, two optical heads are provided on both sides of the to-be-transferred objects 121 and 131. However, such a mechanism can be prepared within a scope of the prior art.

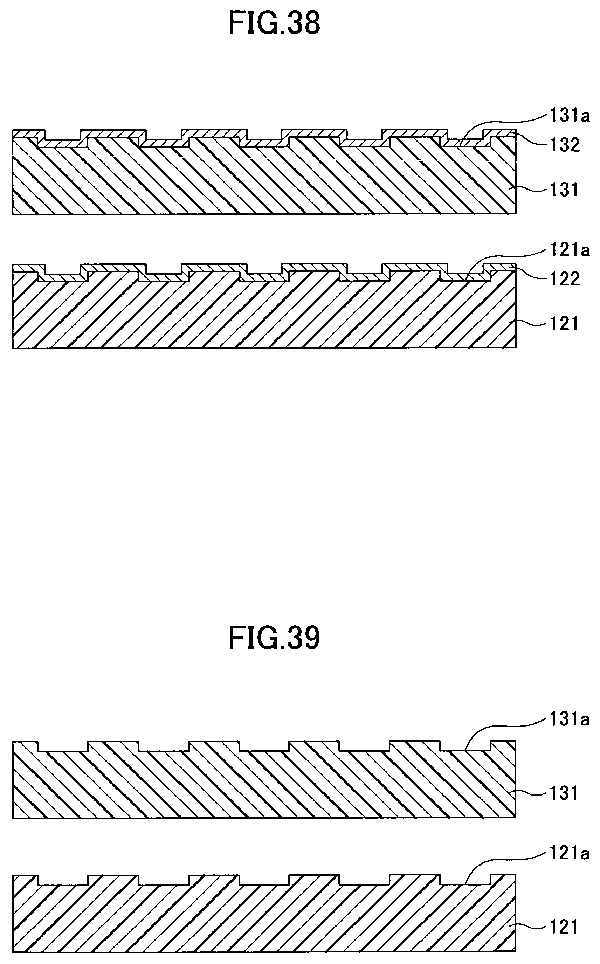

Next, in a process, i.e., a releasing process, as depicted in FIG. 37, the mold 123 is released from each of the to-be-transferred objects 121 and 131, and thus, as depicted in FIG. 38, the indented shapes of the indented surfaces 123a and 123b of the mold 123 are transferred to the to-be-transferred surfaces 121a and 131a of the to-be-transferred objects 121 and 131, respectively. It is noted that, the heating layers 122 and 132 can be removed by means of, for example, wet etching. The wet etching means etching using a liquid chemical which has such a characteristic to corrode and dissolve a target metal or such.

In an imprint method in the related art, a to-be-transferred surface of a to-be-transferred object made of a material which does not transmit electromagnetic waves is irradiated with the electromagnetic waves through a mold which transmits the electromagnetic waves. Thus, the to-be-transferred surface of the to-be-transferred object is softened, and an indented shape of an indented surface of the mold is transferred to the to-be-transferred surface of the to-be-transferred object. That is, in the related art, a material of the mold is limited to a material which transmits the electromagnetic waves, and a material of the to-be-transferred object is limited to a material which does not transmit the electromagnetic waves (i.e., a material which absorbs the electromagnetic waves and generates heat). Therefore, in the related art, it is not possible to perform an imprint method from both sides of to-be-transferred objects which come into contact with a mold from both sides.

In the imprint method according to the fourth mode for carrying out the present invention, the heating layers 122 and 132 which absorb the electromagnetic waves 124 and generate heat are formed on the to-be-transferred surfaces 121a and 131a of the to-be-transferred objects 121 and 131, the heating layers 122 and 132 are irradiated with the electromagnetic waves 124, the heating layers 122 and 132 are thus made to generate heat, whereby the to-be-transferred surfaces 121a and 131a of the to-be-transferred objects 121 and 131 made of materials which transmit the electromagnetic waves 124 are softened. Thus, the indented shapes of the indented surfaces 123a and 123b of the mold 123 are transferred to the to-be-transferred surfaces 121a and 131a of the to-be-transferred objects 121 and 131, respectively.

That is, in the imprint method according to the fourth mode for carrying out the present invention, different from the imprint method in the related art, the to-be-transferred objects 121 and 131 which are made of materials which transmit the electromagnetic waves 24 can be used, and thus, the imprint method (i.e., a both-side imprint method) having higher practicability can be provided. Further, in the imprint method according to the fourth mode for carrying out the present invention, it is possible to provide the imprint method (i.e., the both-side imprint method) which is of a high speed and has improved productivity.

### <Example 12>

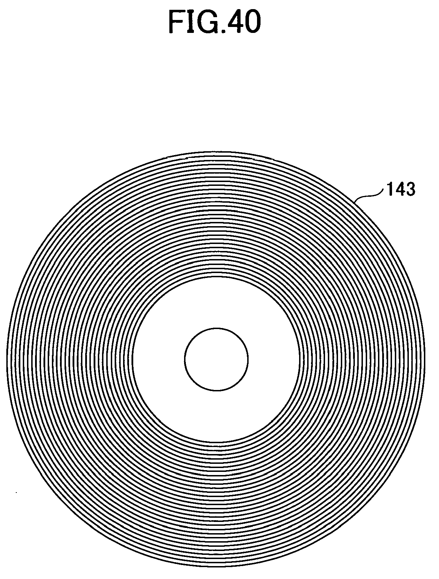

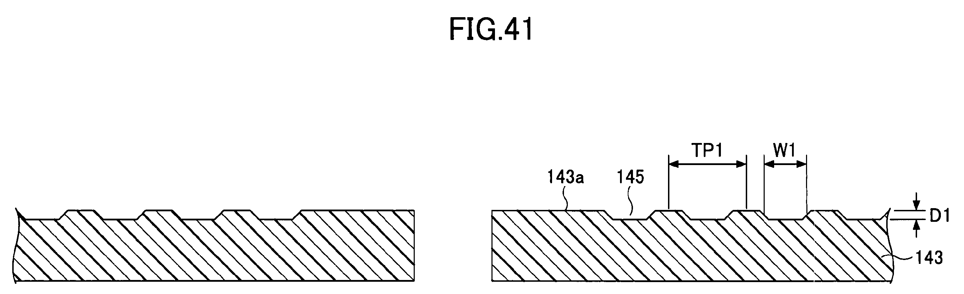

FIG. 40 depicts a schematic plan view of a mold 143 used in an example 12 of the present invention. FIG. 41 depicts a schematic sectional view of the mold 143 used in the example 12 of the present invention. The mold 143 depicted in FIGS. 40 and 41 is a substrate which is used in a HD or DVD-RW disk, made of a polycarbonate resin, of a diameter of approximately *φ*120 mm, a thickness of approximately 0.6 mm, and a diameter of a central hole of approximately *φ*15 mm. A groove (i.e., a depressed portion) 145 of a track pitch TP1 = approximately 400 nm, a groove width W1 = approximately 200 nm, and a depth D1 = approximately 27 nm, is formed spirally on one side of the mold 143 in a range of a diameter between approximately *φ*48 and *φ*118 mm. In the example 12, unless otherwise noted, a mold pattern means a spiral groove 145. A surface on which the groove 145 is formed is referred to as an indented surface 143a.

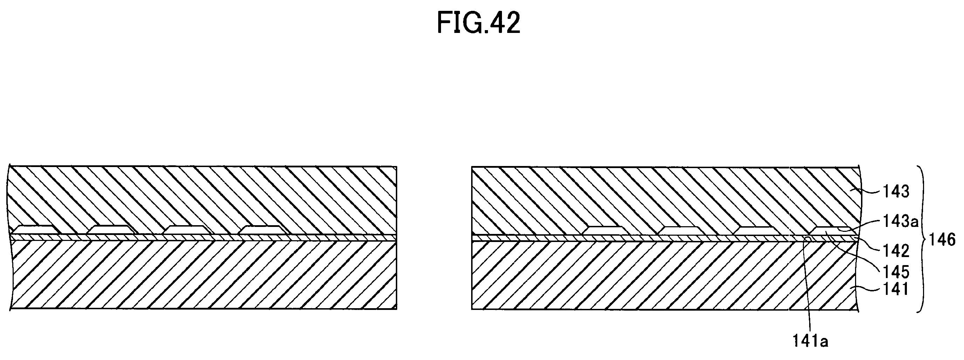

FIG. 42 illustrates a bonded sample 146. As a to-be-transferred object 141, a substrate made of a polycarbonate resin having the same outside dimensions as those of the mold 143 but having no grove 145 formed thereon was prepared. On the to-be-transferred surface 141a of the to-be-transferred object 141, a Ge film (having a film thickness of approximately 10 nm) was formed in a sputtering process as a heating layer 142. As depicted in FIG. 42, the heating layer 142 formed on the to-be-transferred surface 141a of the to-be-transferred object 141 was made to come into contact with protruding portions of the indented surface 143a of the mold 143 in vacuum, they were bonded in a state in which vacuum adsorption was maintained, and thus, the bonded sample 146 was formed.

As an irradiation system to irradiate with electromagnetic waves, POP120-7A made by Hitachi Computer Peripherals Co., Ltd. was used. This irradiation system is one used for initialization of a phase-change type optical recording medium, and mounts an optical head having a semiconductor laser of a wavelength of approximately 830 nm, which is a light source of the electromagnetic waves. This optical head has an automatic focus servo mechanism, and focuses laser light emitted by the semiconductor laser as the light source, on the heating layer 142 of the bonded sample 146. A size of a focused beam is a length of approximately 75 *µ*m in a radius direction of the bonded sample 146 and a width of approximately 1 *µ*m.

An imprint method itself was, approximately the same as initialization of a phase-change type optical recording medium, the bonded sample 146 was placed on a turn table provided in the irradiation system, the bonded sample 146 was then rotated at any rotation speed, focus servo control was carried out, and, in the stated condition, laser light was irradiated with from a side of the to-be-transferred object 141. Further, with the laser light being irradiated with, the optical head was moved in a radius direction of the bonded sample 146, and the entirety of the range in which the groove 145 was formed was irradiated with the laser light.

It is noted that, during the irradiation with laser light, tracking servo control was not carried out. In the example 12, the imprint method was carried out in a setup condition depicted in Table 5. Under the condition, the imprint method may be finished within a time of approximately 40 seconds per sheet. However, in the example 12, for the purpose that a state of the imprint method could be observed, the imprint method was interrupted in the middle.

**Table 5**

| | |
|---|---|
| emitted laser power | 1800 mW |
| optical head feeding speed | 36 *µ*m/revolution |
| rotating line velocity of bonded sample | 8 m/s |

After the irradiation with laser light, the mold 143 and the to-be-transferred object 143 were removed from one another. Then, when the to-be-transferred surface 141a of the to-be-transferred object 141 which had been in contact with the indented surface 143a of the mold 143 was observed visually, interference colors, caused by light interference, the same as those of the indented surface 143a of the mold 143, could be seen. Therefore, it can bee seen that, an indented shape of the indented surface 143a of the mold 143 had been transferred to the to-be-transferred surface 141a of the to-be-transferred object 141. Further, since the interference colors of the to-be-transferred surface 141a of the to-be-transferred object 141 was ended at a part at which laser light irradiation was ended, and no interference colors could be seen in a peripheral part, it can be seen that the above-mentioned transfer of the indented shape was carried out by means of the laser light irradiation.

In order to confirm, in another way, that the indented shape of the indented surface 143a of the mold 143 had been transferred to the to-be-transferred surface 141a of the to-be-transferred object 141, an Ag film was formed on the to-be-transferred surface 141a of the to-be-transferred object 141 for a film thickness of approximately 200 nm. Further, for the purpose of comparison, an Ag film was formed also on the indented surface 143a of the mold 143 for a film thickness of approximately 200 nm.

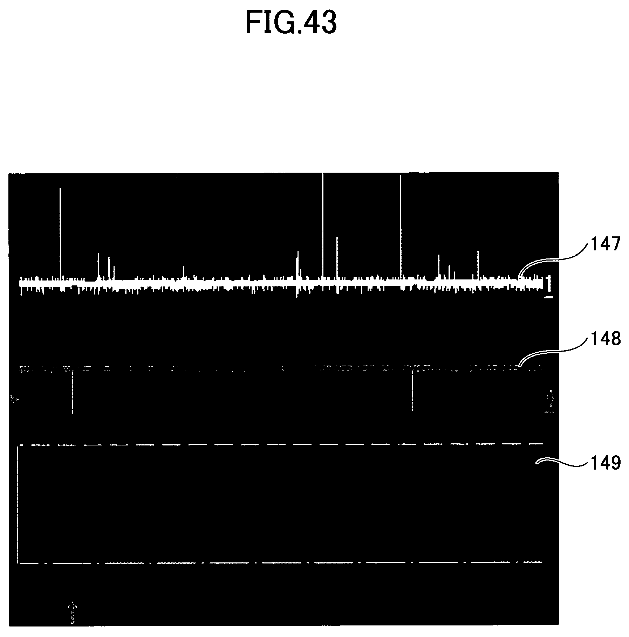

After forming the Ag films, an optical disk evaluation apparatus (ODU-1000 made by Pulstec Industrial Co., Ltd.) was used to check a signal of the to-be-transferred surface 141a of the to-be-transferred object 141 to which the indented shape had been transferred, when tracking servo is turned on and off. FIG. 43 depicts a full light quantity signal 147, a trigger signal 148 and a push-pull signal 149 when the tracking servo was tuned off. The full light quality signal 147 represents reflectance, the trigger signal 148 represents a time corresponding to one turn, and the push-pull signal 149 is used as a tracking error signal or such. Further, the abscissa represents a time and the ordinate represents a voltage. In FIG. 43, the push-pull signal 149 can be seen. Thereby, it can be seen that the indented shape of the indented surface 143a of the mold 143 had been transferred to the to-be-transferred surface 141a of the to-be-transferred object 141.

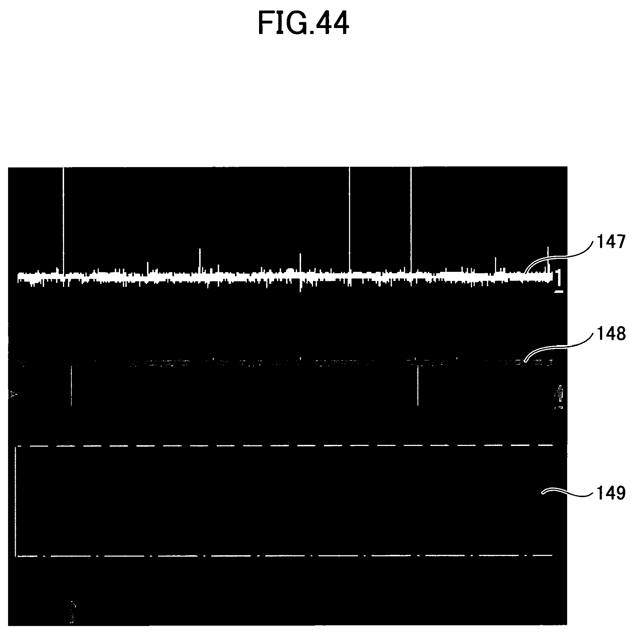

FIG. 44 depicts the full light quantity signal 147, the trigger signal 148 and the push-pull signal 149 when the tracking servo was turned on. The full light quantity 147 signal represents reflectance, the trigger signal 148 represents a time corresponding to one turn and the push-pull signal 149 is used as a tracking error signal or such. Further, the abscissa represents a time and the ordinate represents a voltage. In FIG. 44, as tracking servo could be carried out without any problem, it can be seen that the indented shape of the indented surface 143a of the mold 143 had been satisfactorily transferred to the to-be-transferred surface 141a of the to-be-transferred object 141. It is noted that, in this evaluation with the use of the optical disk evaluation apparatus, the same result could be obtained throughout the area on which laser irradiation was carried out.

According to the present invention, the heating layer 142 which absorbs electromagnetic waves and generates heat is formed on the to-be-transferred surface 141a of the to-be-transferred object 141, the heating layer 142 is irradiated with the electromagnetic waves, the heating layer 142 is thus made to generate heat, and thereby, the to-be-transferred surface 141a of the to-be-transferred object 141 is softened. Therefore, it is possible to transfer an indented shape to the to-be-transferred object 141 which is made of a material which transmits the electromagnetic waves. Thus, it is possible to provide the imprint method having improved practicability.

### Examples 13 through 20>

In each of examples 13 through 20, the same as in the example 12, a heating layer 142 was formed in a sputtering process on a to-be-transferred surface 141a of a to-be-transferred object 141. First, in each of the examples 13 through 15, Ge was used as a material of the heating layer 142, and, the heating layer 142 was formed with a film thickness depicted in Table 6. Thus, the imprint method was carried out. Table 6 also depicts results. Therefrom, it can be seen that the film thickness of Ge has an optimum range in which the indented shape can be transferred. The reason therefor may be as follows. That is, when the film thickness of Ge is too small, laser light may not be sufficiently absorbed, and a heat amount sufficient for transferring the indented shape may not be generated. On the other hand, when the film thickness of Ge is too large, the Ge film itself may radiate heat which the Ge film has once generated.

**Table 6**

| | Ge film thickne ss (nm) | interference colors visually seen/or not seen | groove signal seen/or not seen with optical evaluation apparatus |
|---|---|---|---|
| Example 13 | 5 | not seen | not seen |
| Example 12 | 10 | seen | seen |
| Example 14 | 15 | seen | seen |
| example 15 | 20 | not seen | not seen |

Next, in each of the example 16 through 20, as a material of a heating layer 142, Ag was used, and the heating layer 142 was formed with a film thickness depicted in Table 7, and the imprint method was carried out. Table 7 also depicts results. Transfer of the indented shape could not be carried out regardless of the film thickness of Ag. The reason therefor may be as follows: Heat conductivity of Ag itself may be too high to generate a sufficient heat amount for transferring the indented shape.

In Tables 6 and 7, the film thickness was measured with the use of a spectroscopic ellipsometer (M2000DI made by JA. Woollam). Further, whether a groove signal could be seen with the optical evaluation apparatus was determined from whether the push-pull signal could be seen when the tracking servo is turned off depicted in FIG. 43.

**Table 7**

| | Ag film thickness (nm) | interference colors visually seen/or not seen | groove signal seen/or not seen with optical evaluation apparatus |
|---|---|---|---|
| Example 16 | 2 | not seen | not seen |
| Example 17 | 5 | not seen | not seen |
| Example 18 | 10 | not seen | not seen |
| Example 19 | 15 | not seen | not seen |
| Example 20 | 20 | not seen | not seen |

The results of Tables 6 and 7 show that it is very important to adjust a required heat amount to be generated for transferring the indented shape by a laser light absorbing amount and heat conductivity of the material of the heating layer 142 and a film thickness of the heating layer 142. Such contents could not be found in the related art.

According to the present invention, the heating layer 142 which absorbs electromagnetic waves and generates heat is formed on the to-be-transferred surface 141a of the to-be-transferred object 141, the heating layer 142 is irradiated with the electromagnetic waves, the heating layer 142 is thus made to generate heat, and thereby, the to-be-transferred surface 141a of the to-be-transferred object 141 is softened. Therefore, it is possible to transfer the indented shape to the to-be-transferred object 14 which is made of a material which transmits electromagnetic waves. Thus, it is possible to provide the imprint method having improved practicability.

### <Example 21>

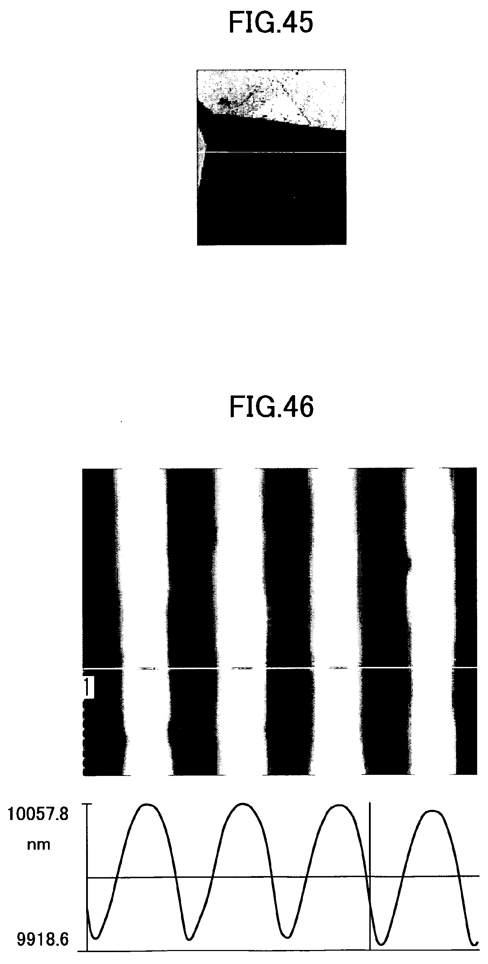

In an example 21, as a mold 153, a commercially available hologram sheet was used, and a both-side imprint method was carried out. FIG. 45 depicts a photomicrograph of the hologram sheet used as the mold 153. The hologram sheet of the mold 153 is a thin sheet of a rectangular parallelepiped having outside dimensions of 25 mm by 20 mm by 0.1 mm. FIG. 46 is an AFM image depicting an indented state of the hologram sheet of the mold 153, and evaluation was carried out with the use of an AFM apparatus (VN-8000 made by KEYENCE CORPORATION). From evaluation of the AFM image depicted in FIG. 46, it can be seen that the hologram sheet of the mold 153 has an indented shape of a height of approximately 130 nm and a pitch of approximately 800 nm (a surface having the indented shape of the hologram sheet of the mold 153 will be referred to as an "indented surface 153a", hereinafter).

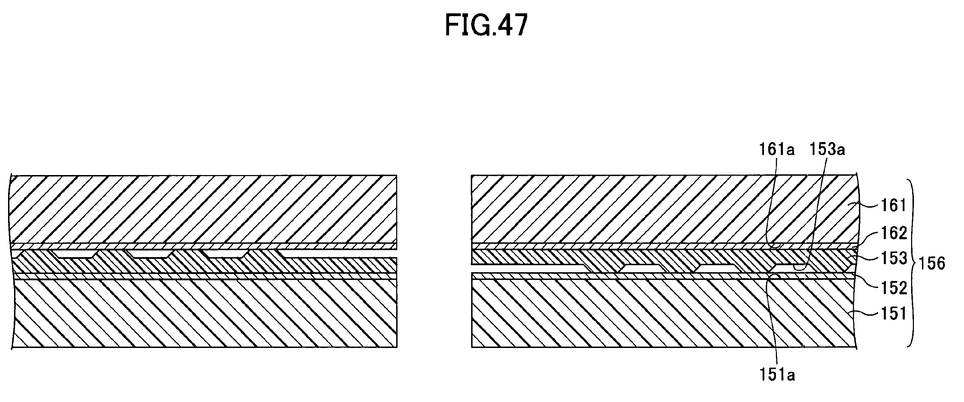

FIG. 47 illustrates a bonded sample 156. Two sheets of the molds 153 were prepared. As each of to-be-transferred objects 151 and 161, a substrate made of a polycarbonate resin on which no groove 145 was formed, having outside dimensions the same as those of the mold 143 depicted in FIG. 40, was prepared. Then, in the same method as that of the embodiment 12, a Ge film (having a film thickness of approximately 10 nm) was formed in a sputtering process as heating layers 152 and 162, on to-be-transferred surfaces 151a and 161a of the to-be-transferred objects 151 and 161. As depicted in FIG. 47, in a condition in which, the indented surface 153a of the first mold 153 faces upward and the indented surface 153a of the second mold 153 faces downward, and, in vacuum, with the two molds 153 being made not to overlap one another, protruding portions of the first indented surface 153a and the heating layer 52 formed on the to-be-transferred surface 151a of the to-be-transferred object 151 were made to come into contact, protruding portions of the second indented surface 153a and the heating layer 162 formed on the to-be-transferred surface 161a of the to-be-transferred object 161 were made to come into contact. Thus, bonding was carried out in a state in which vacuum adsorption was maintained, and a bonded sample 156 was formed.

The thus-formed bonded sample 156 was irradiated with laser light, in the same procedure as that in the example 12. However, there was a part in which no mold 153 exists between the to-be-transferred objects 151 and 161 because of a relationship of dimensions between the molds 153 and the to-be-transferred objects 151 and 161. Therefore, when an automatic focusing mechanism is used, an apparatus stops at the part at winch the mold 153 does not exist. For this reason, a fixed focus method was used. A setup condition depicted in Table 8 was used.

**Tab 8**

| | |
|---|---|
| emitted laser power | 2000 mW |
| optical head feeding speed | 36 *µ*m/revolution |
| rotating line velocity of bonded sample (m/s) | 4 m/s |

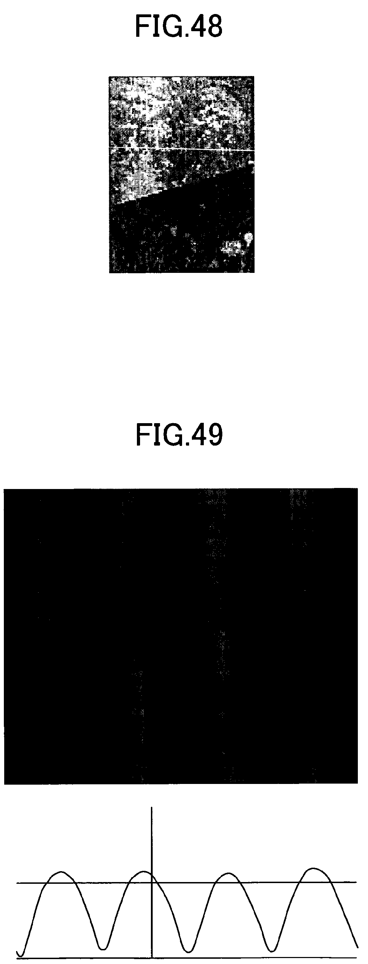

Laser light was irradiated with, side by side, then the to-be-transferred objects 151 and 161 were removed, and the to-be-transferred surfaces 151a and 161a of the to-be-transferred objects 151 and 161, which had been in contact with the molds 153, were visually observed. As a result, interference colors, caused by light interference, the same as those of the molds 153, could be seen. FIG. 48 is a photomicrograph of the to-be-transferred surface 151a of the to-be-transferred object 151. FIG. 49 depicts an AFM image depicting a state of the to-be-transferred surface 151a of the to-be-transferred object 151, and evaluation was carried out with the use of an AFM apparatus (VN-8000 made by KEYENCE CORPORATION). From evaluation with the use of the AFM apparatus, it could be confirmed that the to-be-transferred surface 151a of the to-be-transferred object 151 had an indented shape of a height of approximately 70 nm and a pitch of approximately 820 nm. In the same method, it could be confirmed that, also the to-be-transferred surface 161a of the to-be-transferred object 161 had the same indented shape as that of the to-be-transferred surface 151a of the to-be-transferred object 151.

Except that the indented shape thus transferred to each of the to-be-transferred surfaces 151a and 161a of the to-be-transferred objects 151 and 161 has the height approximately on the order of half of the indented shape of the indented surface 153a of the hologram sheet of the mold 153, the indented shapes of the molds 153 had been satisfactorily transferred to the to-be-transferred surfaces 151a and 161a of the to-be-transferred objects 151 and 161, respectively. A cause of the height being thus approximately on the order of half may be that, because focusing of laser light was carried out in the fixed focusing method, focusing might not be carried out sufficiently, and thereby, a sufficient heat might not be generated. Therefore, it can be seen that, by adjusting a laser light irradiation condition (especially, a parameter concerning light intensity), it is possible to adjust a shape and a size of a to-be-transferred object.

In the example 21, because of an experiment environment, two hologram sheets each having the indented surface 153a on one side were used as the molds 153. Then, in a condition in which, the indented surface 153a of the first mold 153 faces upward and the indented surface 153a of the second mold 153 faces downward, and, in vacuum, with the two molds 153 being made not to overlap one another, the to-be-transferred objects 151 and 161 and the molds 153 are overlaid together in such a condition that the molds 152 are inserted between the to-be-transferred objects 151 and 161. Thus, bonding was carried out in a state in which vacuum adsorption was maintained, and a bonded sample 156 was formed.

However, from the result of the example 21, it can be easily imagined that, the both-side imprint method described above as the fourth mode for carrying out the present invention can be realized, in which, a mold having indented surfaces on both sides is used, the mold is inserted between two to-be-transferred objects made of materials which transmit electromagnetic waves, irradiated with the electromagnetic waves is carried out through the two to-be-transferred objects, and indented shape of the indented surfaces are transferred to the to-be-transferred surfaces of the to-be-transferred objects.

According to the present invention, the both-side imprint method can be achieved, and thus, it is possible to provide an imprint method having higher practicability. Further, according to the present invention, it is possible to provide an imprint method having high speed and improved productivity.

### <Example 22>

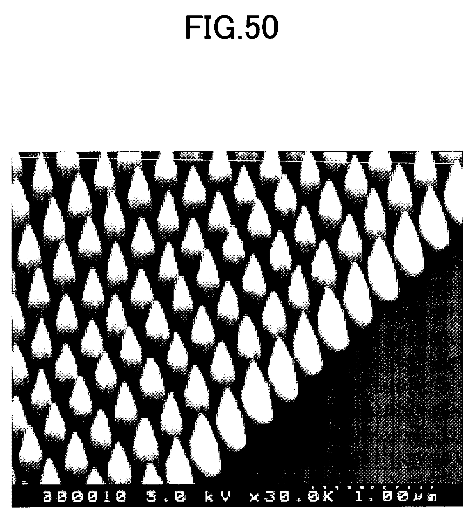

In an example 22, in the same way as that of the example 12, on a to-be-transferred surface 141a of a to-be-transferred object 141, a Ge film (with a film thickness of approximately 10 nm) was formed in a sputtering process as a heating layer 142. As a mold, a quartz substrate having the same shape as that of the mold 143 used in the example 12 was prepared. On a surface of the thus-prepared quartz substrate as the mold, a texture structure depicted in FIG. 50 was formed. FIG. 50 depicts a photomicrograph of the texture structure formed on the surface of the quartz substrate as the mold. A size of the texture structure depicted in FIG. 50 is such that, a dot pitch is 400 nm and a height is 500 nm. The texture structure depicted in FIG. 50 corresponds to the indented surface 143a of the embodiment 12. It is noted that, the texture structure means a repeated pattern which is disposed according to a predetermined rule, and, for example, a structure having many fine indented shapes on its surface.

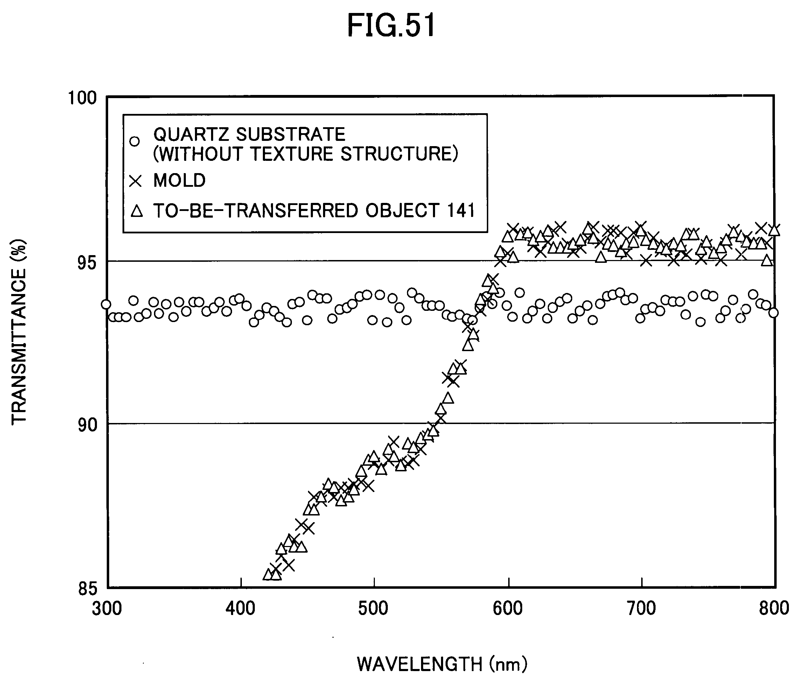

Next, in the same method as that in the example 12, the texture structure formed on the surface of the quartz substrate as the mold was transferred to the to-be-transferred surface 141a of the to-be-transferred object 141. FIG. 51 illustrates a light transmission spectrum of the to-be-transferred object 141. In FIG. 51, a symbol Δ represents the to-be-transferred object 141 to which the texture structure had been transferred to the to-be-transferred surface 141a, a symbol X represents the quartz substrate as the mold having the texture structure formed on the surface thereof, and a symbol ○ represents a quartz substrate having no texture structure formed on a surface thereof. Transmittance of the mold and the quartz substrate is depicted for the purpose of comparison to transmittance of the to-be-transferred object 141.

As can be seen from FIG. 51, the to-be-transferred object 141 (Δ) and the quartz substrate used as the mold for transfer (X), in the same manner, have the transmittance which is higher than that of the quartz substrate (○) in a wavelength zone of equal to or higher than 600 nm. This is because of a reflection preventing function provided by the texture structure. Since the to-be-transferred object 41 has a characteristic equivalent to that of the quartz substrate used as the mold for transfer, it can be seen that transfer had been carried out satisfactorily.

From the above-mentioned result, it can be seen that, according to the present invention, such a mold having a texture structure on its surface can be used in the imprint method, and transfer of the texture structure can be achieved.

### <Example 23>

In an example 23, in the same way as that in the example 12, on a to-be-transferred surface 141a of a to-be-transferred object 141, a Ge film (with a film thickness of approximately 10 nm) was formed as a heating layer 142 in a sputtering process. Then, in the same way as that in the example 12, a bonded sample 146 was formed. Thus, the imprint method is carried out in such a manner that the bonded sample was irradiated with laser light from the side of the mold 143. To the thus-formed to-be-transferred object 141, tracking was carried out with the use of the evaluation apparatus used in the example 12, and thus, 2500 tracks (i.e., a width of approximately 1 mm) were scanned. At this time, a rotating line velocity of the to-be-transferred object 141 was changed as depicted in Table 9, and it was checked whether tracking failure occurred. A symbol ○ represents that no tracking failure occurred and a symbol X represents that tracking failure occurred. For the purpose of comparison, a case of the example 12 is also depicted in Table 9. As depicted in Table 9, it could be seen that, tracking failure occurred when a rotating line velocity became higher than a predetermined value, for the to-be-transferred object 141 in which the imprint method was carried out in such a condition that laser light was irradiated with from the side of the mold 143.

**Table 9**

| rotating line velocity (m/s) | whether tracing failure occurred in example 23 | whether tracing failure occurred in example 12 |
|---|---|---|
| 2 | ○ | ○ |
| 5 | ○ | ○ |
| 10 | ○ | ○ |
| 15 | ○ | ○ |
| 20 | ○ | ○ |
| 25 | × | ○ |
| 30 | × | ○ |
| 35 | × | ○ |

From the above-mentioned results, it can be seen that, it is possible to provide the imprint method in which transferring performance is improved by irradiation of laser light from the side of a to-be-transferred object.

## Claims

1. An imprint method comprising, in a state in which an indented surface (11a, 21a, 21 b, 113a, 123a, 123b) of a mold (11, 21, 113, 123) comes into contact with a to-be-transferred-to surface (13a, 23a, 33a, 111a, 121a, 131a) of a to-be-transferred-to object (13, 23, 33, 111, 121, 131), irradiating with electromagnetic waves, softening the to-be-transferred-to surface (13a, 23a, 33a, 111a, 121a, 131a), and transferring an indented shape of the indented surface (11 a, 21 a, 21 b, 113a, 123a, 123b) to the to-be-transferred-to surface (13a, 23a, 33a, 111a, 121a, 131a), said imprint method further comprising:
a heating layer forming step of forming, on the indented surface (11a, 21a, 21 b, 113a, 123a, 123b) or the to-be-transferred-to surface (13a, 23a, 33a, 111a, 121a, 131a), a heating layer (12, 22, 32, 112, 122, 132) which absorbs the electromagnetic waves and generates heat,
a softening step of irradiating the heating layer (12, 22, 32, 112, 122, 132) with the electromagnetic waves, through the mold (11, 113, 123) or the to-be-transferred-to object (13, 23, 33, 111, 121, 131) at least one of the mold (11, 113, 123) and the to-be-transferred-to object (13, 23, 33, 111, 121, 131) being made of a material which transmits the electromagnetic waves, causing the heating layer (12, 22, 32, 112, 122, 132) to generate heat, and softening the to-be-transferred-to surface (13a, 23a, 33a, 111a, 121a, 131 a),
**characterised in that**
the heating layer has a configuration of a plurality of layers which are laminated together.

2. The imprint method as claimed in claim 1, wherein:
the mold (21, 123) has another indented surface (21a, 21b, 123a, 123b), and another to-be-transferred-to object (23, 33, 121, 131) has another to-be-transferred-to surface (23a, 33a, 121a, 131a),
in a state in which the two indented surfaces of the mold (21, 123) come into contact with the two to-be-transferred-to surfaces (23a, 33a, 121a, 131a) of the two to-be-transferred-to objects (23, 33, 121, 131), the electromagnetic waves are irradiated with, the two to-be-transferred-to surfaces (23a, 33a, 121a, 131a) are softened, and indented shapes of the two indented surfaces (21a, 21 b, 123a, 123b) are transferred to the two to-be-transferred-to surfaces (21a, 21 b, 123a, 123b),
in the heating layer forming step, on the two indented surfaces (21a, 21 b, 123a, 123b) or on the two to-be-transferred-to surfaces (21a, 21b, 123a, 123b), heating layers (22, 32, 122, 132) which absorb the electromagnetic waves and generate heat are formed, and
in the softening step, the heating layers (22, 32, 122, 132) are irradiated with the electromagnetic waves, through the two to-be-transferred-to surfaces (21a, 21 b, 123a, 123b) made of materials which transmit the electromagnetic waves, the heating layers (22, 32, 122, 132) are caused to generate heat, and the to-be-transferred-to surfaces (21a, 21 b, 123a, 123b) are softened.

3. The imprint method as claimed in claim 2, wherein:
in the softening step, the heating layers (22, 32, 122, 132) are irradiated with the electromagnetic waves through the two to-be-transferred-to objects (121, 131) simultaneously.

4. The imprint method as claimed in any one of claims 1 through 3, wherein:
the softening step comprises a focusing step of focusing the electromagnetic waves being irradiated with, on the heating layer (12, 22, 32, 112, 122, 132).

5. The imprint method as claimed in claim 4, wherein:
in the focusing step, focus servo control is carried out.

6. The imprint method as claimed in any one of claims 1 through 5, wherein:
a film thickness of the heating layer (12, 22, 32, 112, 122, 132) is determined in consideration of an electromagnetic wave absorbing amount and heat conductivity of a material of the heating layer.

7. The imprint method as claimed in any one of claims 1 through 6, wherein:
a material of the heating layer (12, 22, 32, 112, 122, 132) is any one of a metal, a semiconductor, a dielectric, a semimetal and an organic material, or a mixture of at least any two of a metal, a semiconductor, a dielectric, a semimetal and an organic material, and
the material of the heating layer comprises a phase change material.

8. The imprint method as claimed in any one of claims 1 through 7, wherein:
the maximum wavelength of the electromagnetic waves is equal to or smaller than 2000 nm.

9. The imprint method as claimed in any one of claims 1 through 8, wherein:
the electromagnetic waves comprise laser light, and
a laser used to irradiate with the laser light is a semiconductor laser.

10. The imprint method as claimed in any one of claims 1 through 9, wherein:
the mold is in the form of a film.

## Patentansprüche

1. Prägeverfahren, umfassend, in einem Zustand, in dem eine eingekerbte Oberfläche (11a, 21a, 21b, 113a, 123a, 123b) einer Matrize (11, 21, 113, 123) mit einer Übertragungsempfangsfläche (13a, 23a, 33a, 111a, 121a, 131a) eines Übertragungsempfangsobjekts (13, 23, 33, 111, 121, 131) in Kontakt kommt, das Bestrahlen mit elektromagnetischen Wellen, das Aufweichen der Übertragungsempfangsfläche (13a, 23a, 33a, 111a, 121a, 131a) und das Übertragen einer eingekerbten Form der eingekerbten Oberfläche (11a, 21a, 21b, 113a, 123a, 123b) auf die Übertragungsempfangsfläche (13a, 23a, 33a, 111a, 121a, 131a), wobei das Prägeverfahren ferner Folgendes umfasst:
einen Heizschichtbildungsschritt zum Bilden auf der eingekerbten Oberfläche (11a, 21a, 21b, 113a, 123a, 123b) oder der Übertragungsempfangsfläche (13a, 23a, 33a, 111a, 121a, 131a) einer Heizschicht (12, 22, 32, 112, 122, 132), welche die elektromagnetischen Wellen absorbiert und Wärme erzeugt, und
einen Aufweichschritt zum Bestrahlen der Heizschicht (12, 22, 32, 112, 122, 132) mit den elektromagnetischen Wellen durch die Matrize (11, 113, 123) oder das Übertragungsempfangsobjekt (13, 23, 33, 111, 121, 131) hindurch, wobei mindestens entweder die Matrize (11, 113, 123) oder das Übertragungsempfangsobjekt (13, 23, 33, 111, 121, 131) aus einem Material besteht, dass die elektromagnetischen Wellen durchlässt, was bewirkt, dass die Heizschicht (12, 22, 32, 112, 122, 132) Wärme erzeugt und die Übertragungsempfangsfläche (13a, 23a, 33a, 111a, 121a, 131a) aufgeweicht wird,
**dadurch gekennzeichnet, dass**
die Heizschicht eine Konfiguration einer Vielzahl von Schichten aufweist, die zusammen laminiert sind.

2. Prägeverfahren nach Anspruch 1, wobei:
die Matrize (21, 123) eine andere eingekerbte Oberfläche (21a, 21b, 123a, 123b) aufweist, und ein anderes Übertragungsempfangsobjekt (23, 33, 121, 131) eine andere Übertragungsempfangsfläche (23a, 33a, 121a, 131a) aufweist,
in einem Zustand, in dem die beiden eingekerbten Oberflächen der Matrize (21, 123) mit den beiden Übertragungsempfangsflächen (23a, 33a, 121a, 131a) der beiden Übertragungsempfangsobjekte (23, 33, 121, 131) in Kontakt kommen, die elektromagnetischen Wellen ausgestrahlt werden, die beiden Übertragungsempfangsflächen (23a, 33a, 121a, 131a) aufgeweicht werden, und die eingekerbten Formen der beiden eingekerbten Oberflächen (21a, 21b, 123a, 123b) auf die beiden Übertragungsempfangsflächen (21a, 21b, 123a, 123b) übertragen werden,
in dem Heizschichtbildungsschritt auf den beiden eingekerbten Oberflächen (21a, 21b, 123a, 123b) oder auf den beiden Übertragungsempfangsflächen (21a, 21b, 123a, 123b) Heizschichten (22, 32, 122, 132) gebildet werden, welche die elektromagnetischen Wellen absorbieren und Wärme erzeugen, und
in dem Aufweichschritt die Heizschichten (22, 32, 122, 132) mit den elektromagnetischen Wellen bestrahlt werden, durch die beiden Übertragungsempfangsflächen (21a, 21b, 123a, 123b) hindurch, die aus Materialien bestehen, welche die elektromagnetischen Wellen durchlassen, die Heizschichten (22, 32, 122, 132) veranlasst werden, Wärme zu erzeugen, und die Übertragungsempfangsflächen (21a, 21b, 123a, 123b) aufgeweicht werden.

3. Prägeverfahren nach Anspruch 2, wobei:
in dem Aufweichschritt die Heizschichten (22, 32, 122, 132) gleichzeitig mit den elektromagnetischen Wellen durch die beiden Übertragungsempfangsobjekte (121, 131) hindurch bestrahlt werden.

4. Prägeverfahren nach einem der Ansprüche 1 bis 3, wobei:
der Aufweichschritt einen Fokussierungsschritt zum Fokussieren der ausgestrahlten elektromagnetischen Wellen auf die Heizschicht (12, 22, 32, 112, 122, 132) umfasst.

5. Prägeverfahren nach Anspruch 4, wobei:
in dem Fokussierungsschritt eine Fokusservosteuerung ausgeführt wird.

6. Prägeverfahren nach einem der Ansprüche 1 bis 5, wobei:
eine Foliendicke der Heizschicht (12, 22, 32, 112, 122, 132) unter Berücksichtigung einer Absorptionsmenge der elektromagnetischen Wellen und einer Wärmeleitfähigkeit eines Materials der Heizschicht bestimmt wird.

7. Prägeverfahren nach einem der Ansprüche 1 bis 6, wobei:
ein Material der Heizschicht (12, 22, 32, 112, 122, 132) eines von Metall, einem Halbleiter, einem Dielektrikum, einem Halbmetall und einem organischen Material oder eine Mischung von mindestens zweien von einem Metall, einem Halbleiter, einem Dielektrikum, einem Halbmetall und einem organischen Material ist, und
das Material der Heizschicht ein Phasenwechselmaterial umfasst.

8. Prägeverfahren nach einem der Ansprüche 1 bis 7, wobei:
die maximale Wellenlänge der elektromagnetischen Wellen gleich oder kleiner als 2000 nm ist.

9. Prägeverfahren nach einem der Ansprüche 1 bis 8, wobei:
die elektromagnetischen Wellen Laserlicht umfassen, und
ein Laser, der verwendet wird, um das Laserlicht auszustrahlen, ein Halbleiterlaser ist.

10. Prägeverfahren nach einem der Ansprüche 1 bis 9, wobei:
die Matrize die Form einer Folie aufweist.

## Revendications

1. Procédé d'impression comprenant, dans un état dans lequel une surface indentée (11a, 21a, 21b, 113a, 123a, 123b) d'un moule (11, 21, 113, 123) entre en contact avec une surface cible du transfert (13a, 23a, 33a, 111a, 121a, 131a), d'un objet cible du transfert (13, 23, 33, 111, 121, 131), une irradiation avec des ondes électromagnétiques, un ramollissement de la surface cible du transfert (13a, 23a, 33a, 111a, 121a, 131a) et le transfert d'une forme indentée de la surface indentée (11a, 21a, 21b, 113a, 123a, 123b) vers la surface cible du transfert (13a, 23a, 33a, 111a, 121a, 131a), ledit procédé d'impression comprenant en outre :
une étape de formation de couche de chauffage pour former sur la surface indentée (11a, 21a, 21b, 113a, 123a, 123b) ou sur la surface du transfert (13a, 23a, 33a, 111a, 121a, 131a), une couche de chauffage (12, 22, 32, 112, 122, 132) qui absorbe les ondes électromagnétiques et génère de la chaleur,
une étape de ramollissement consistant dans l'irradiation de la couche de chauffage (12, 22, 32, 112, 122, 132) avec les ondes électromagnétiques, à travers le moule (11, 113, 123) ou l'objet cible du transfert (13, 23, 33, 111, 121, 131), au moins un parmi le moule (11, 113, 123) et l'objet cible du transfert (13, 23, 33, 111, 121, 131) étant constitué d'un matériau qui transmet les ondes électromagnétiques, ce qui permet à la couche de chauffage (12, 22, 32, 112, 122, 132) de générer de la chaleur et ramollir la surface cible du transfert (13a, 23a, 33a, 111a, 121a, 131a),
**caractérisé en ce que**
la couche de chauffage présente une configuration d'une pluralité de couches qui sont laminées ensemble.

2. Procédé d'impression selon la revendication 1, dans lequel :
le moule (21, 123) présente une autre surface indentée (21a, 21b, 123a, 123b) et un autre objet cible du transfert (23, 33, 121, 131) présente une autre surface cible du transfert (23a, 33a, 121a, 131a),
dans un état dans lequel les deux surfaces indentées du moule (21, 123) entrent en contact avec les deux surfaces cibles du transfert (23a, 33a, 121a, 131a) des deux objets cibles du transfert (23, 33, 121, 131), les ondes électromagnétiques sont émises, les deux surfaces cibles du transfert (23a, 33a, 121a, 131a) sont ramollies et les formes indentées des deux surfaces indentées (21a, 21b, 123a, 123b) sont transférées sur les deux surfaces cibles du transfert (21a, 21b, 123a, 123b),
dans l'étape de formation de couche de chauffage, sur les deux surfaces indentées (21a, 21b, 123a, 123b) ou sur les deux surfaces cibles du transfert (21a, 21b, 123a, 123b), des couches de chauffage (22, 32, 122, 132) qui absorbent les ondes électromagnétiques et génèrent de la chaleur sont formées, et
dans l'étape de ramollissement, les couches de chauffage (22, 32, 122, 132) sont irradiées avec les ondes électromagnétiques, à travers les deux surfaces cibles du transfert (21a, 21b, 123a, 123b) constituées de matériaux qui transmettent les ondes électromagnétiques, les couches de chauffage (22, 32, 122, 132) génèrent de la chaleur et les surfaces cibles du transfert (21a, 21b, 123a, 123b) sont ramollies.

3. Procédé d'impression selon la revendication 2, dans lequel :
dans l'étape de ramollissement, les couches de chauffage (22, 32, 122, 132) sont irradiées avec les ondes électromagnétiques à travers les deux objets cibles du transfert (121, 131) simultanément.

4. Procédé d'impression selon l'une des revendications 1 à 3, dans lequel :
l'étape de ramollissement comprend une étape de focalisation des ondes électromagnétiques irradiées sur la couche de chauffage (12, 22, 32, 112, 122, 132).

5. Procédé d'impression selon la revendication 4, dans lequel :
dans l'étape de focalisation, une servo-commande de focalisation est exécutée.

6. Procédé d'impression selon l'une des revendications 1 à 5, dans lequel :
une épaisseur de film de la couche de chauffage (12, 22, 32, 112, 122, 132) est déterminée en fonction d'une valeur absorbant une onde électromagnétique et d'une conductivité thermique d'un matériau de la couche de chauffage.

7. Procédé d'impression selon l'une des revendications 1 à 6, dans lequel :
un matériau de la couche de chauffage (12, 22, 32, 112, 122, 132) est sélectionné parmi un métal, un semi-conducteur, un diélectrique, un semi-métal et un matériau organique ou un mélange d'au moins deux parmi un métal, un semi-conducteur, un diélectrique, un semi-métal et un matériau organique, et
le matériau de la couche de chauffage comprend un matériau à changement de phase.

8. Procédé d'impression selon l'une des revendications 1 à 7, dans lequel :
la longueur d'onde maximale des ondes électromagnétiques est inférieure ou égale à 2000 nm.

9. Procédé d'impression selon l'une des revendications 1 à 8, dans lequel :
les ondes électromagnétiques comprennent une lumière laser et
un laser utilisé pour irradier avec la lumière laser est un laser à semi-conducteur.

10. Procédé d'impression selon l'une des revendications 1 à 9, dans lequel :
le moule se présente sous la forme d'un film.
